# EUROPEAN PATENT APPLICATION

(11) **EP 4 629 803 A1**
(43) Date of publication of application: **08.10.2025**
(21) Application number: 25167569.0
(22) Date of filing: 31.03.2025
(51) Int. Cl.: H10K 59/131, H10K 71/70

(54) **DISPLAY DEVICE**

(30) Priority: 02.04.2024 KR 20240044626
(71) Applicant: Samsung Display Co., Ltd., Gyeonggi-Do (KR)
(72) Inventor: LEE, Chang-Yeol, Yongin-si (KR); KIM, Hansol, Yongin-si (KR); MOON, Joong-soo, Yongin-si (KR); CHO, Youngjin, Yongin-si (KR); KIM, Jaewon, Yongin-si (KR)
(74) Representative: Marks & Clerk LLP

(57) **Abstract**

Disclosed is a display device including a detection line (EL-T) disposed in a non-display area, first power lines (PL1) connected to pixels to provide a first driving voltage, and a second power line (PL2) including first lines (PL2-1 to PL2-e) and a second line (PL2-S) that provides a second driving voltage to the pixels, wherein the detection line includes extension lines (EL-T) spaced apart from each other by the display area , a bridge line (EL-B) connected to the first power lines, and connection lines (EL-C) connecting one of the extension lines and an end portion of the bridge line as well as another one of the extension lines and another end portion of the bridge line, and the second power line overlaps the connection lines in a plan view.

## Description

### BACKGROUND

### 1. Technical Field

Embodiments of the disclosure described herein relate to a display device having improved display quality.

### 2. Description of the Related Art

Generally, electronic devices such as smart phones, digital cameras, laptop computers, navigation devices, and smart televisions which provide images to users include display devices for displaying the images. The display device generates the image and provides the generated image to the user through a display screen.

The display device includes multiple pixels for generating the image and multiple lines connected to the pixels. The pixels are driven by receiving driving signals through the lines.

In medium and large display devices having large areas such as tablets or smart televisions, there may be a difference between a driving voltage provided from a lower end and a driving voltage transferred from an upper end, and a design that compensates for this difference is required.

### SUMMARY

Embodiments of the disclosure provide a large-area display device that may provide a uniform driving voltage to pixels.

According to an embodiment, a display device includes a substrate including a display area and a non-display area surrounding the display area, insulating layers disposed on the substrate, pixels disposed in the display area, first power lines disposed in a first direction, each of the first power lines extending in a second direction intersecting the first direction, the first power lines connected to the pixels to provide a first driving voltage, a second power line including first lines disposed in the display area and connected to the pixels and a second line connected to the first lines, the second line disposed in the non-display area, the second power line to provide a second driving voltage having a lower voltage level than that of the first driving voltage, and a detection line disposed in the non-display area and surrounding at least a portion of the display area, wherein the detection line includes extension lines each extending in the second direction and spaced apart from each other in the first direction by the display area, a bridge line extending in the first direction, connected to the first power lines, and including end portions, and connection lines connecting the end portions of the bridge line to corresponding ones of the extension lines, and the second line intersects the connection lines in a plan view.

The extension lines may be disposed further apart from the display area than the second line. The bridge line may be disposed closer to the display area than the second line.

Each of the extension lines may include a sensing pattern and a power pattern disposed on the sensing pattern and connected to the sensing pattern.

The display device may further include an outer dam disposed in the non-display area and surrounding the at least a portion of the display area. The display device may include an inner dam disposed between the outer dam and the display area. The outer dam may include a first dam pattern, a second dam pattern, a third dam pattern and a fourth dam pattern, which in some examples may be sequentially laminated on the insulating layers. The inner dam may include a fifth dam pattern and a sixth dam pattern, which in some examples may be sequentially laminated on the insulating layers.

The sensing pattern may be covered by the first dam pattern. The power pattern may be disposed on the first dam pattern and may be covered by the second dam pattern. The sensing pattern may be connected to the sensing pattern through at least one contact hole passing through the first dam pattern.

Each of the sensing pattern and the power pattern may include a first conductive pattern, a second conductive pattern, and a third conductive pattern, which in some examples may be sequentially laminated. The first conductive pattern and the third conductive pattern may include titanium. The second conductive pattern may include aluminum. A side surface of the second conductive pattern may be recessed inward from a side surface of each of the first conductive pattern and the third conductive pattern.

The first dam pattern and the second dam pattern may include organic materials. The first dam pattern may cover the side surface of each of the first conductive pattern, the second conductive pattern, and the third conductive pattern of the sensing pattern. The second dam pattern may cover the side surface of each of the first conductive pattern, the second conductive pattern, and the third conductive pattern of the power pattern.

The second line may extend from an inside of the inner dam to an inside of the outer dam. The second line may include a first pattern. The first pattern and the sensing pattern may include a same material. The second line may include a second pattern. The second pattern and the power pattern may include a same material.

The first pattern and the second pattern may be in contact with each other inside the inner dam and may be spaced apart from each other inside the outer dam with the first dam pattern disposed between the first pattern and the second pattern.

Each of the pixels may include an anode, a cathode disposed on the anode, and a light emitting layer disposed between the anode and the cathode. The cathode may extend to the non-display area and may be in contact with the second pattern.

Each of the pixels may include a lower metal layer disposed on the substrate. Each of the pixels may include a first semiconductor layer overlapping the lower metal layer. Each of the pixels may include a first gate electrode overlapping the first semiconductor layer. Each of the pixels may include a dummy electrode overlapping the first gate electrode. Each of the pixels may include a second semiconductor layer spaced apart from the first semiconductor layer. Each of the pixels may include a second gate electrode overlapping the second semiconductor layer. Each of the pixels may further include a first connection electrode connected to the first semiconductor layer and a second connection electrode connecting the first connection electrode and the anode.

The insulating layers may include a buffer layer disposed on the substrate to cover the lower metal layer. The insulating layers may include a first insulating layer disposed on the buffer layer to cover the first semiconductor layer. The insulating layers may include a second insulating layer disposed on the first insulating layer to cover the first gate electrode. The insulating layers may include a third insulating layer disposed on the second insulating layer to cover the dummy electrode. The insulating layers may include a fourth insulating layer disposed on the third insulating layer to cover the second semiconductor layer. The insulating layers may include a fifth insulating layer disposed on the fourth insulating layer to cover the second gate electrode. The insulating layers may include a sixth insulating layer disposed on the fifth insulating layer to cover the first connection electrode. The sixth insulating layer may include an organic material. The insulating layers may include a seventh insulating layer disposed on the sixth insulating layer. The seventh insulating layer may cover the second connection electrode. The seventh insulating layer may include an organic material. The first connection electrode may be connected to the first semiconductor layer through a first contact hole passing through the first insulating layer, the second insulating layer, the third insulating layer, the fourth insulating layer, and the fifth insulating layer. The second connection electrode may be connected to the first connection electrode through a second contact hole passing through the sixth insulating layer. The anode may be connected to the second connection electrode through a third contact hole passing through the seventh insulating layer.

The display device may further include a pixel defining film including an organic material disposed on the seventh insulating layer. The pixel defining film may include first openings defined through which at least portions of the anodes may be exposed. The pixel defining film may include a spacer including an organic material disposed on the pixel defining film. The spacer may include second openings overlapping the first openings.

The first dam pattern and the sixth insulating layer may include a same material. The second dam pattern and the seventh insulating layer may include a same material. The third dam pattern, the fifth dam pattern, and the pixel defining film may include a same material. The fourth dam pattern, the sixth dam pattern, and the spacer may include a same material.

The sensing pattern and the first connection electrode may include a same material. The power pattern and the second connection electrode may include a same material.

The connection lines may be disposed on the first insulating layer and may be covered by the second insulating layer. The connection lines and the first gate electrode may include a same material. The power pattern may be connected to the connection lines through contact holes passing through the second insulating layer, the third insulating layer, the fourth insulating layer, and the fifth insulating layer.

The bridge line may be disposed on the first insulating layer and may be covered by the second insulating layer. The connection lines and the bridge line may be integral with each other.

The bridge line may be disposed on the second insulating layer, and the bridge line may be covered by the third insulating layer. The bridge line and the dummy electrode may include a same material. The bridge line may be connected to the connection lines through contact holes passing through the second insulating layer.

The bridge line may be disposed on the fourth insulating layer, and the bridge line may be covered by the fifth insulating layer. The bridge line and the second gate electrode may include a same material. The bridge line may be connected to the connection lines through contact holes passing through the second insulating layer, the third insulating layer, the fourth insulating layer.

The bridge line may be disposed on the first insulating layer, and the bridge line may be covered by the second insulating layer. The bridge line and the first gate electrode may include a same material. The connection lines may be disposed on the second insulating layer, and the connection lines may be covered by the third insulating layer, The connection lines and the dummy electrode may include a same material. The sensing pattern may be connected to an end portion of the connection lines through first contact holes passing through the third insulating layer, the fourth insulating layer, and the fifth insulating layer. Another end portion of the connection lines may be connected to the bridge line through second contact holes passing through the second insulating layer.

The bridge line may be disposed on the first insulating layer, and the bridge line may be covered by the second insulating layer. The bridge line and the first gate electrode may include a same material. The connection lines may be disposed on the fourth insulating layer, and the connection lines may be covered by the fifth insulating layer. The connection lines and the second gate electrode may include a same material. The sensing pattern may be connected to an end portion of the connection lines through first contact holes passing through the fifth insulating layer Another end portion of the connection lines may be connected to the bridge line through second contact holes passing through the second insulating layer, the third insulating layer, and the fourth insulating layer.

A width of the second line may be greater than a width of each of the extension lines in a plan view.

At least some of the above and other features of the invention are set out in the claims.

### BRIEF DESCRIPTION OF THE DRAWINGS

The above and other objects and features of the disclosure will become apparent by describing in detail embodiments thereof with reference to the accompanying drawings.
Fig. 1 is a schematic plan view of a display device according to an embodiment of the disclosure.
FIG. 2 is a schematic cross-sectional view of the display device illustrated in FIG. 1.
FIG. 3 is a schematic cross-sectional view of a display panel illustrated in FIG. 2.
FIG. 4 is a schematic block diagram of the display device illustrated in FIG. 1.
FIG. 5 is a schematic diagram of an equivalent circuit of a pixel among pixels illustrated in FIG. 4.
FIG. 6 is a timing diagram of scan signals and light emitting signals for describing an operation of the pixel illustrated in FIG. 5.
FIG. 7 is a schematic cross-sectional view of a light emitting element, a first transistor, a fourth transistor, and a sixth transistor of the pixel illustrated in FIG 5.
FIG. 8 is a schematic plan view of the display panel according to an embodiment of the disclosure.
FIG. 9 is a schematic cross-sectional view along line I-I' of FIG. 8.
FIG. 10 is a schematic cross-sectional view along line II-II' of FIG. 8.
FIG. 11 is a schematic cross-sectional view along line III-III' of FIG. 8.
FIGS. 12 to 16 are schematic cross-sectional views of areas corresponding to FIG. 11.
FIG. 17 is a schematic cross-sectional view of the display panel according to an embodiment of the disclosure.

### DETAILED DESCRIPTION OF THE EMBODIMENTS

In the following description, for the purposes of explanation, numerous specific details are set forth in order to provide a thorough understanding of various embodiments or implementations of the disclosure. As used herein "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

Unless otherwise specified, the illustrated embodiments are to be understood as providing features of the disclosure. Therefore, unless otherwise specified, the features, components, modules, layers, films, panels, regions, and/or aspects, etc., (hereinafter individually or collectively referred to as "elements"), of the various embodiments may be otherwise combined, separated, interchanged, and/or rearranged without departing from the disclosure.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals and/or reference characters denote like elements.

When an element, such as a layer, is referred to as being "on,'' "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the X-axis, the Y-axis, and the Z-axis are not limited to three axes of a rectangular coordinate system, such as the x, y, and z axes, and may be interpreted in a broader sense. For example, the X-axis, the Y-axis, and the Z-axis may be perpendicular to one another, or may be different directions that are not perpendicular to one another.

For the purposes of this disclosure, "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc., may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one element's relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some embodiments are described and illustrated in the accompanying drawings in terms of functional blocks, parts, and/or modules. Those skilled in the art will appreciate that these blocks, parts, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, parts, and/or modules being implemented by microprocessors or other similar hardware, they may be programmed and controlled using software (e.g., microcode) to perform various functions discussed herein and may optionally be driven by firmware and/or software. It is also contemplated that each block, part, and/or module may be implemented by dedicated hardware, or as a combination of dedicated hardware to perform some functions and a processor (e.g., one or more programmed microprocessors and associated circuitry) to perform other functions. Also, each block, part, and/or module of some embodiments may be physically separated into two or more interacting and discrete blocks, parts, and/or modules without departing from the scope of the disclosure. Further, the blocks, parts, and/or modules of some embodiments may be physically combined into more complex blocks, parts, and/or modules without departing from the scope of the disclosure.

Unless otherwise defined or implied herein, all terms (including technical and scientific terms) used herein have the same meaning as commonly understood by those skilled in the art to which this disclosure pertains. It will be further understood that terms, such as those defined in commonly used dictionaries, should be interpreted as having a meaning that is consistent with their meaning in the context of the relevant art and the disclosure, and should not be interpreted in an ideal or excessively formal sense unless clearly so defined herein.

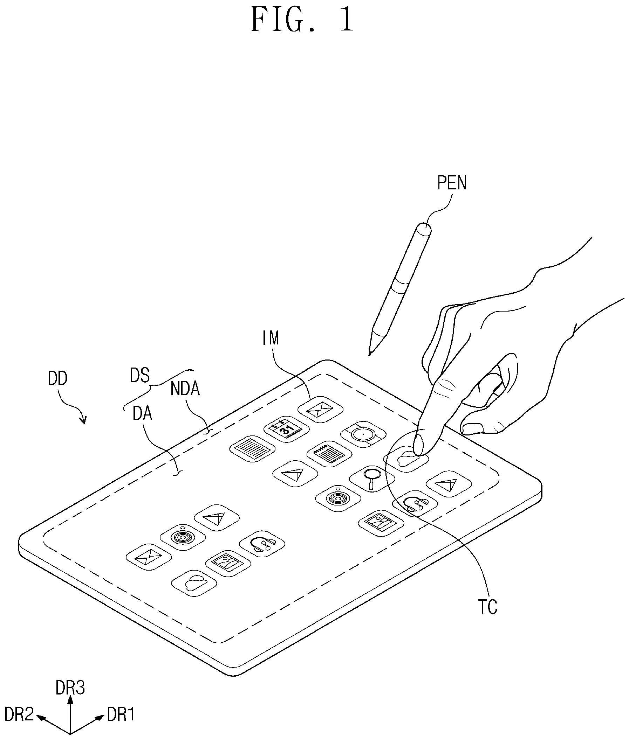

FIG. 1 is a schematic plan view of a display device according to an embodiment of the present disclosure.

Referring to FIG. 1, a display device DD according to an embodiment of the disclosure may have long sides extending in parallel in a first direction DR1 and short sides extending in parallel in a second direction DR2 intersecting the first direction DR1. Corners of the display device DD, which connect the long sides and the short sides, may have a curved shape. The corners of the display device DD having the curved shape may be defined as rounded corners. The shape of the display device DD may be defined as a rounded corner quadrangular shape.

Hereinafter, a direction substantially perpendicular to a plane defined by the first direction DR1 and the second direction DR2 is defined as a third direction DR3. Further, in the specification, the expression "when viewed on a plane" is defined as a state of being viewed from the third direction DR3 or in a plan view.

A front surface of the display device DD may be defined as a display surface DS and may have the plane defined by the first direction DR1 and the second direction DR2. Images IM generated by the display device DD may be provided to a user through the display surface DS.

The display surface DS may include a display area DA and a non-display area NDA around the display area DA. The display area DA displays an image, and the non-display area NDA does not display the image. The non-display area NDA may surround the display area DA and define an edge of the display device DD, which is printed in a color (e.g., predetermined or selectable color).

The display area DA may have a rounded corner quadrangular shape according to the shape of the display device DD. For example, the display area DA may include sides of a quadrangle extending in the first direction DR1 and the second direction DR2 and rounded corners connecting the sides. Sides extending in the first direction DR1 among the four sides may be defined as long sides, and sides extending in the second direction DR2 among the four sides may be defined as short sides.

The display device DD may sense inputs applied from the outside of the display device DD. For example, the display device DD may sense a first input by a touch pen PEN and a second input by a touch TC. The touch pen PEN may be defined as an input device.

The touch pen PEN may be an active pen that outputs a signal. The second input by the touch TC may include various types of external inputs such as a portion of a body of the user, light, heat, or pressure.

The display device DD and the touch pen PEN may bidirectionally communicate with each other. The display device DD may provide an uplink signal to the touch pen PEN. For example, the uplink signal may include information such as panel information and a protocol version, but the disclosure is not limited thereto.

The touch pen PEN may provide a downlink signal to the display device DD. The downlink signal may include a synchronization signal or status information of the touch pen PEN. For example, the downlink signal may include coordinate information of the touch pen PEN, battery information of the touch pen PEN, inclination information of the touch pen PEN and/or various pieces of information stored in the touch pen PEN, but the disclosure is not limited thereto.

The display device DD may be used for large-sized electronic devices such as televisions, monitors, or external billboards. Further, the display device DD may be used for small or medium-sized electronic devices such as a personal computer (PC), a laptop, a personal digital terminal, a vehicle navigation system, a game console, a smart phone, a tablet PC, or a camera. However, these are merely presented as an embodiment, and the display device DD may be used for other electronic devices as long as the other electronic devices do not deviate from the concept of the disclosure.

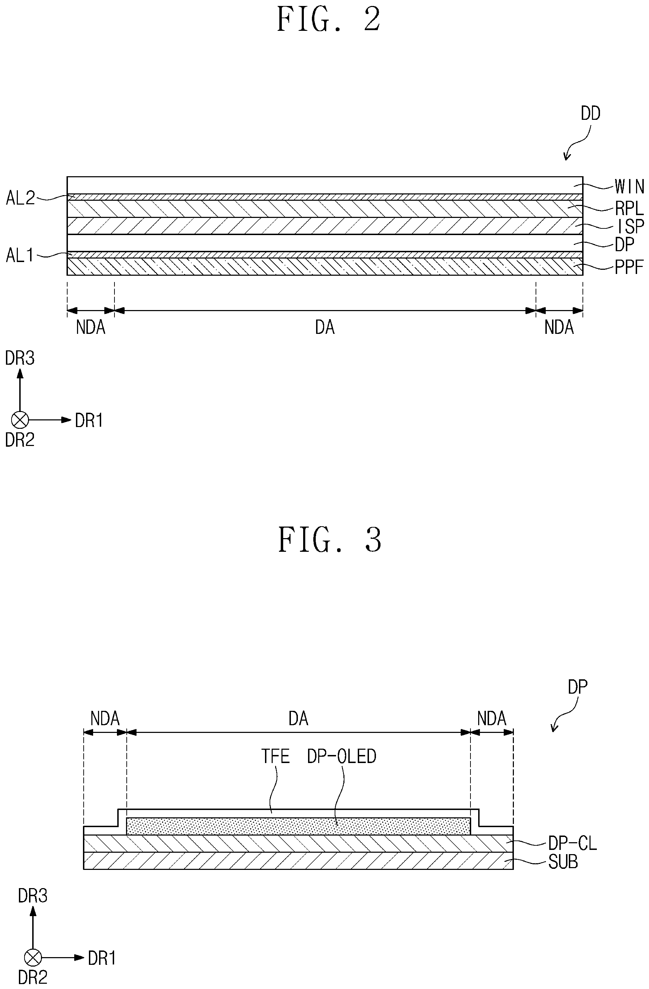

FIG. 2 is a schematic cross-sectional view of the display device illustrated in FIG. 1.

Illustratively, FIG. 2 is a schematic cross-sectional view of the display device DD when viewed in the second direction DR2.

Referring to FIG. 2, the display device DD may include a display panel DP, an input sensing portion ISP, a reflection preventing layer RPL, a window WIN, a panel protecting film PPF, and first and second adhesive layers AL1 and AL2.

The display panel DP according to an embodiment of the disclosure may be a light emitting display panel. For example, the display panel DP may be an organic light emitting display panel or an inorganic light emitting display panel. A light emitting layer of the organic light emitting display panel may include an organic light emitting material. A light emitting layer of the inorganic light emitting display panel may include a quantum dot and a quantum rod. Hereinafter, the display panel DP will be described as the organic light emitting display panel.

The input sensing portion ISP may be disposed on the display panel DP. The input sensing portion ISP may include multiple sensing portions (not illustrated) for sensing an external input in a capacitive manner. The input sensing portion ISP may be manufactured (e.g., directly manufactured) on the display panel DP when the display device DD is manufactured. However, the disclosure is not limited thereto, and the input sensing portion ISP may be manufactured (e.g., directly manufactured) as a separate panel from the display panel DP and attached to the display panel DP by an adhesive layer.

The reflection preventing layer RPL may be disposed on the input sensing portion ISP. The reflection preventing layer RPL may be manufactured (e.g., directly manufactured) on the input sensing portion ISP when the display device DD is manufactured. However, the disclosure is not limited thereto, and the reflection preventing layer RPL may be manufactured as a separate panel and attached to the input sensing portion ISP by an adhesive layer.

The reflection preventing layer RPL may be defined as an external light reflection preventing film. The reflection preventing layer RPL may reduce a reflectance of an external light input from an upper side of the display device DD toward the display panel DP. The external light may not be visually recognized by the user due to the reflection preventing layer RPL.

In case that an external light traveling toward the display panel DP is reflected by the display panel DP and provided back to an external user, the user may visually recognize the external light like a mirror. To prevent this phenomenon, illustratively, the reflection preventing layer RPL may include multiple color filters that display the same colors as those of the pixels of the display panel DP.

The color filters may filter the external light into the same colors as those of the pixels. As a result, the external light may not be visually recognized by the user. However, the disclosure is not limited thereto, and the reflection preventing layer RPL may include a phase retarder and/or a polarizer to reduce the reflectance of the external light.

The window WIN may be disposed on the reflection preventing layer RPL. The window WIN may protect the display panel DP, the input sensing portion ISP, and the reflection preventing layer RPL from external scratches and impacts.

The panel protecting film PPF may be disposed under the display panel DP. The panel protecting film PPF may protect a lower portion of the display panel DP. The panel protecting film PPF may include a flexible plastic material such as polyethyleneterephthalate (PET).

The first adhesive layer AL1 may be disposed between the display panel DP and the panel protecting film PPF, and the display panel DP and the panel protecting film PPF may adhere to each other by the first adhesive layer AL1. The second adhesive layer AL2 may be disposed between the window WIN and the reflection preventing layer RPL, and the window WIN and the reflection preventing layer RPL may adhere to each other by the second adhesive layer AL2.

FIG. 3 is a schematic cross-sectional view of a display panel illustrated in FIG. 2.

Illustratively, FIG. 3 illustrates a schematic cross section of the display panel DP when viewed in the second direction DR2.

Referring to FIG. 3, the display panel DP may include a substrate SUB, a circuit element layer DP-CL disposed on the substrate SUB, a display element layer DP-OLED disposed on the circuit element layer DP-CL, and a thin film encapsulation layer TFE disposed on the display element layer DP-OLED.

The substrate SUB may include the display area DA and the non-display area NDA around the display area DA. The substrate SUB may include glass or a flexible plastic material such as polyimide (PI). The display element layer DP-OLED may be disposed on the display area DA.

Multiple pixels may be disposed in the circuit element layer DP-CL and the display element layer DP-OLED. Each of the pixels may include a transistor disposed in the circuit element layer DP-CL and a light emitting element disposed in the display element layer DP-OLED and connected to the transistor.

The thin film encapsulation layer TFE may be disposed on the circuit element layer DP-CL to cover the display element layer DP-OLED. The thin film encapsulation layer TFE may protect the pixels from moisture, oxygen, and foreign material.

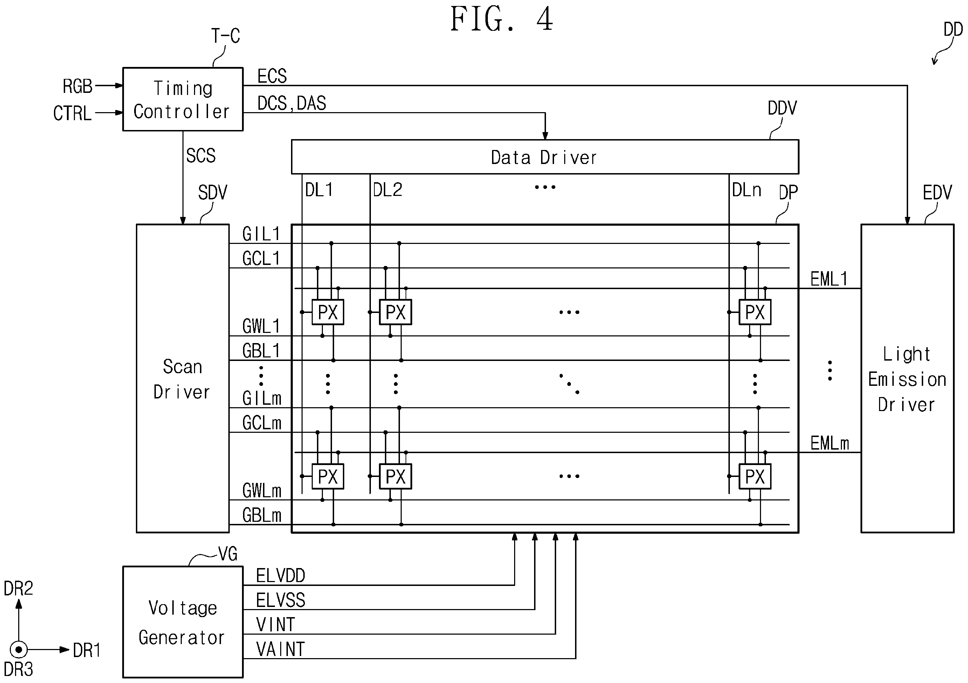

FIG. 4 is a schematic block diagram of the display device illustrated in FIG. 1.

Referring to FIG. 4, the display device DD may include the display panel DP, a timing controller T-C, a scan driver SDV, a data driver DDV, a light emission driver EDV, and a voltage generator VG.

The display panel DP may include multiple scan lines GIL1 to GILm, GCL1 to GCLm, GWL1 to GWLm, and GBL1 to GBLm, multiple light emitting lines EML1 to EMLm, multiple data lines DL1 to DLn, and multiple pixels PX, where "m" and "n" may be positive integers.

The pixels PX may be electrically connected to the scan lines GIL1 to GILm, GCL1 to GCLm, GWL1 to GWLm, and GBL1 to GBLm, the light emitting lines EML1 to EMLm, and the data lines DL1 to DLn. Each of the pixels PX may be electrically connected to corresponding four scan lines, corresponding one data line, and corresponding one light emitting line.

The scan lines GIL1 to GILm, GCL1 to GCLm, GWL1 to GWLm, and GBL1 to GBLm may include the initialization scan lines GIL1 to GILm, the compensation scan lines GCL1 to GCLm, the writing scan lines GWL1 to GWLm, and the bias scan lines GBL1 to GBLm.

Each of the pixels PX may be connected to a corresponding one of the initialization scan lines GIL1 to GILm, a corresponding one of the compensation scan lines GCL1 to GCLm, a corresponding one of the writing scan lines GWL1 to GWLm, and a corresponding one of the bias scan lines GBL1 to GBLm.

The scan lines GIL1 to GILm, GCL1 to GCLm, GWL1 to GWLm, and GBL1 to GBLm may be connected to the scan driver SDV, may extend in the first direction DR1, and may be disposed in the second direction DR2. The light emitting lines EML1 to EMLm may be connected to the light emission driver EDV, may extend in the first direction DR1, and may be disposed in the second direction DR2. The data lines DL1 to DLn may be connected to the data driver DDV, may extend in the second direction DR2, and may be disposed in the first direction DR1.

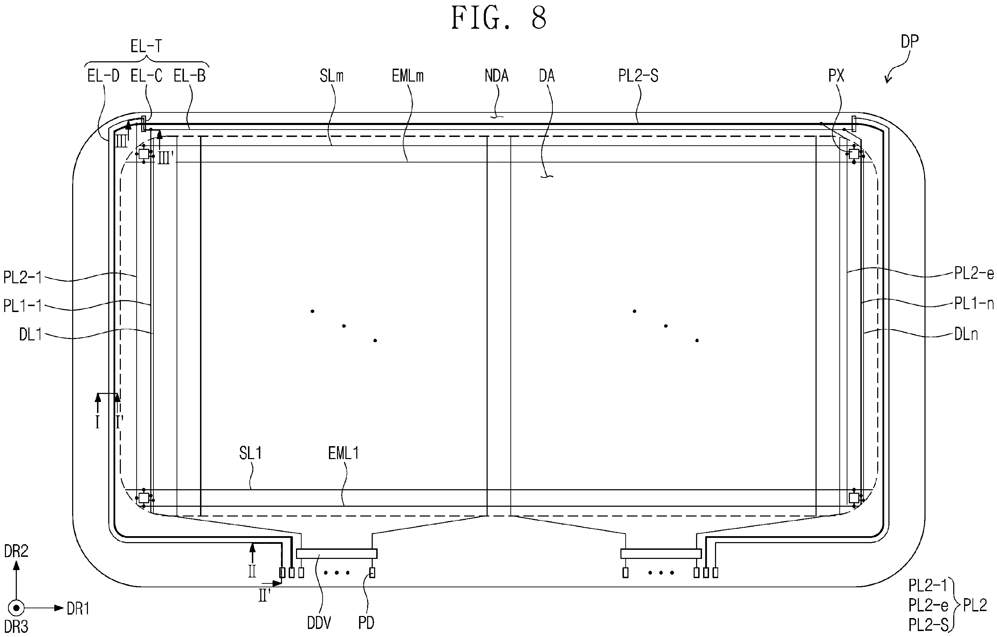

The scan driver SDV, the light emission driver EDV, and the data driver DDV may be substantially disposed on the display panel DP, and these components will be illustrated below in FIG. 8.

The timing controller T-C may receive an image signal RGB and a control signal CTRL. The timing controller T-C may generate an image data signal DAS obtained by converting a data format of the image signal RGB to satisfy interface specifications with the data driver DDV. The timing controller T-C may output a scan control signal SCS, a data control signal DCS, and a light emitting control signal ECS in response to the control signal CTRL.

The voltage generator VG may generate voltages required for operating the display panel DP. The voltage generator VG may generate a first driving voltage ELVDD, a second driving voltage ELVSS, a first initialization voltage VINT, and a second initialization voltage VAINT. The first driving voltage ELVDD, the second driving voltage ELVSS, the first initialization voltage VINT, and the second initialization voltage VAINT may be applied to the pixels PX.

The scan driver SDV may receive the scan control signal SCS from the timing controller T-C. The scan driver SDV may output scan signals to the scan lines GIL1 to GILm, GCL1 to GCLm, GWL1 to GWLm, and GBL1 to GBLm in response to the scan control signal SCS. The scan signals may be applied to the pixels PX through the scan lines GIL1 to GILm, GCL1 to GCLm, GWL1 to GWLm, and GBL1 to GBLm.

The data driver DDV may receive the data control signal DCS and the image data signal DAS from the timing controller T-C. The data driver DDV may convert the image data signal DAS into data signals and output the converted data signals. The data signals may be defined as analog voltages corresponding to the grayscale level of the image data signal DAS. The data signals may be applied to the pixels PX through the data lines DL1 to DLn.

The light emission driver EDV may receive the light emitting control signal ECS from the timing controller T-C. The light emission driver EDV may output light emitting signals to the light emitting lines EML1 to EMLm in response to the light emitting control signal ECS. The light emitting signals may be applied to the pixels PX through the light emitting lines EML1 to EMLm.

The pixels PX may receive the data voltages in response to the scan signals. The pixels PX may display an image by emitting light having brightness corresponding to the data voltages in response to the light emitting signals.

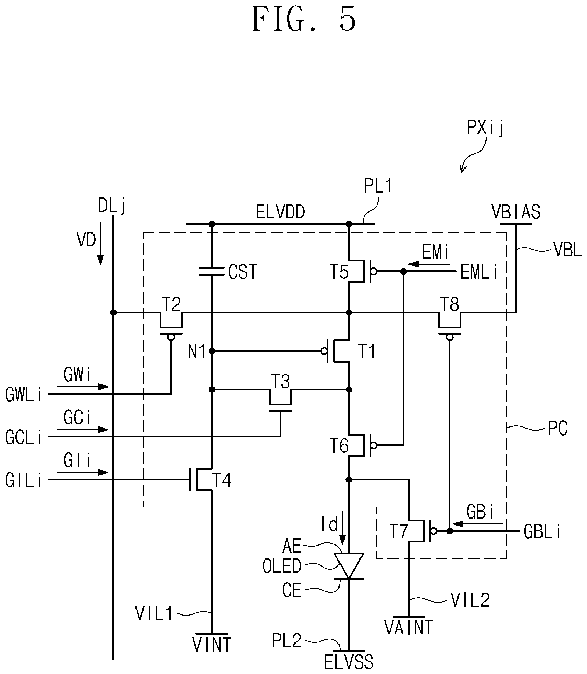

FIG. 5 is a schematic diagram of an equivalent circuit of a pixel among pixels illustrated in FIG. 4.

Illustratively, FIG. 5 illustrates a pixel PXij connected to a j^{th} data line DLj, i^{th} scan lines GWLi, GCLi, GILi, and GBLi, and an i^{th} light emitting line EMLi, where "i" and "j" may be positive integers.

Referring to FIG. 5, the pixel PXij may include a pixel circuit PC and a light emitting element OLED connected to the pixel circuit PC. The pixel circuit PC may drive the light emitting element OLED.

The pixel circuit PC may include multiple transistors T1 to T8 and a capacitor CST. The transistors T1 to T8 and the capacitor CST may control the amount of a current flowing through the light emitting element OLED. The light emitting element OLED may generate light having brightness (e.g., predetermined or selectable brightness) according to the amount of provided current.

The i^{th} writing scan line GWLi may receive an i^{th} writing scan signal GWi, and the i^{th} compensation scan line GCLi may receive an i^{th} compensation scan signal GCi. The i^{th} initialization scan line GILi may receive an i^{th} initialization scan signal GIi, and the i^{th} bias scan line GBLi may receive an i^{th} bias scan signal GBi. The i^{th} light emitting line EMLi may receive an i^{th} light emitting signal EMi.

The pixel PXij may be connected to the j^{th} data line DLj, the i^{th} writing scan line GWLi, the i^{th} compensation scan line GCLi, the i^{th} initialization scan line GILi, the i^{th} bias scan line GBLi, the i^{th} light emitting line EMLi, a first initialization line VIL1, a second initialization line VIL2, a bias line VBL, and first and second power lines PL1 and PL2.

The first initialization line VIL1 may receive the first initialization voltage VINT, and the second initialization line VIL2 may receive the second initialization voltage VAINT. The bias line VBL may receive a bias voltage VBIAS. The first power line PL1 may receive the first driving voltage ELVDD, and the second power line PL2 may receive the second driving voltage ELVSS.

Each of the transistors T1 to T8 may include a source electrode, a drain electrode, and a gate electrode. Hereinafter, in FIG. 5, for convenience, one of the source electrode and the drain electrode is defined as a first electrode, and another thereof is defined as a second electrode. Further, the gate electrode is defined as a control electrode.

The transistors T1 to T8 may include the first to eighth transistors T1 to T8. The first, second, and fifth to eighth transistors T1, T2, and T5 to T8 may be p-type metal oxide semiconductor (PMOS) transistors. The third and fourth transistors T3 and T4 may be n-type metal oxide semiconductor (NMOS) transistors.

The first transistor T1 may be defined as a driving transistor, and the second transistor T2 may be defined as a switching transistor. The third transistor T3 may be defined as a compensation transistor. The fourth transistor T4 and the seventh transistor T7 may be defined as initialization transistors. The fifth transistor T5 and the sixth transistor T6 may be defined as light emitting control transistors. The eighth transistor T8 may be defined as a bias transistor.

The light emitting element OLED may be defined as an organic light emitting element. The light emitting element OLED may include an anode AE and a cathode CE. The anode AE may receive the first driving voltage ELVDD through the sixth, first, and fifth transistors T6, T1, and T5. The first driving voltage ELVDD may be applied to the pixel circuit PC through the first power line PL1.

The cathode CE may receive the second driving voltage ELVSS having a lower level than that of the first driving voltage ELVDD. The second driving voltage ELVSS may be applied to the pixel circuit PC through the second power line PL2.

The first transistor T1 may be disposed between the fifth transistor T5 and the sixth transistor T6 and connected to the fifth transistor T5 and the sixth transistor T6. The first transistor T1 may be connected to the first power line PL1 through the fifth transistor T5 and connected to the anode AE through the sixth transistor T6.

The first transistor T1 may include a first electrode connected to the first power line PL1 through the fifth transistor T5, a second electrode connected to the anode AE through the sixth transistor T6, and a control electrode connected to a first node N1.

The first electrode of the first transistor T1 may be connected to the fifth transistor T5, and the second electrode of the first transistor T1 may be connected to the sixth transistor T6. The first transistor T1 may control the amount of current flowing through the light emitting element OLED according to a voltage of the first node N1 applied to the control electrode of the first transistor T1.

The second transistor T2 may be disposed between the first transistor T1 and the j^{th} data line DLj and connected to the first transistor T1 and the j^{th} data line DLj. The second transistor T2 may include a first electrode connected to the j^{th} data line DLj, a second electrode connected to the first electrode of the first transistor T1, and a control electrode connected to the i^{th} writing scan line GWLi.

The second transistor T2 may be turned on by the i^{th} writing scan signal GWi applied through the i^{th} writing scan line GWLi and electrically connect the j^{th} data line DLj and the first electrode of the first transistor T1. The second transistor T2 may perform a switching operation of providing a data voltage VD (corresponding to the above-described data signal) applied through the j^{th} data line DLj to the first electrode of the first transistor T1.

The third transistor T3 may be connected to the second electrode of the first transistor T1 and the first node N1. The third transistor T3 may include a first electrode connected to the second electrode of the first transistor T1, a second electrode connected to the first node N1, and a control electrode connected to the i^{th} compensation scan line GCLi.

The third transistor T3 may be turned on by the i^{th} compensation scan signal GCi applied through the i^{th} compensation scan line GCLi and electrically connect the second electrode of the first transistor T1 and the control electrode of the first transistor T1. In case that the third transistor T3 is turned on, the first transistor T1 and the third transistor T3 may be diode-connected to each other.

The fourth transistor T4 may be connected to the first node N1. The fourth transistor T4 may include a first electrode connected to the first node N1, a second electrode connected to the first initialization line VIL1, and a control electrode connected to the i^{th} initialization scan line GILi. The fourth transistor T4 may be turned on by the i^{th} initialization scan signal GIi applied through the i^{th} initialization scan line GILi and provide the first initialization voltage VINT applied through the first initialization line VIL1 to the first node N1.

The fifth transistor T5 may include a first electrode connected to the first power line PL1, a second electrode connected to the first electrode of the first transistor T1, and a control electrode connected to the i^{th} light emitting line EMLi.

The sixth transistor T6 may include a first electrode connected to the second electrode of the first transistor T1, a second electrode connected to the anode AE, and a control electrode connected to the i^{th} light emitting line EMLi.

The fifth transistor T5 and the sixth transistor T6 may be turned on by the i^{th} light emitting signal EMi applied through the i^{th} light emitting line EMLi. The first driving voltage ELVDD may be provided to the light emitting element OLED by the turned-on fifth transistor T5 and the turned-on sixth transistor T6, so that a driving current Id may flow in the light emitting element OLED. Thus, the light emitting element OLED may emit light.

The seventh transistor T7 may include a first electrode connected to the anode AE, a second electrode connected to the second initialization line VIL2, and a control electrode connected to the i^{th} bias scan line GBLi. The seventh transistor T7 may be turned on by the i^{th} bias scan signal GBi applied through the i^{th} bias scan line GBLi and provide the second initialization voltage VAINT received through the second initialization line VIL2 to the anode AE of the light emitting element OLED.

In an embodiment of the disclosure, the second initialization voltage VAINT may have a different level from the first initialization voltage VINT, but the disclosure is not limited thereto, and the second initialization voltage VAINT may have the same level as the first initialization voltage VINT.

The seventh transistor T7 may improve black expression capability of the pixel PXij. In a case that the seventh transistor T7 is turned on, a parasitic capacitor (not illustrated) of the light emitting element OLED may be discharged. Thus, in case that black brightness is implemented, the light emitting element OLED does not emit light due to a leakage current of the first transistor T1, and accordingly, the black expression capability may be improved.

The capacitor CST may include a first electrode connected to the first power line PL1 and a second electrode connected to the first node N1. In a case that the fifth transistor T5 and the sixth transistor T6 are turned on, the amount of current flowing through the first transistor T1 may be determined according to a voltage stored in the capacitor CST.

The eighth transistor T8 may include a first electrode connected to the bias line VBL, a second electrode connected to the first electrode of the first transistor T1, and a control electrode connected to the i^{th} bias scan line GBLi.

The eighth transistor T8 may be turned on by the i^{th} bias scan signal GBi and provide the bias voltage VBIAS applied through the bias line VBL to the first electrode of the first transistor T1.

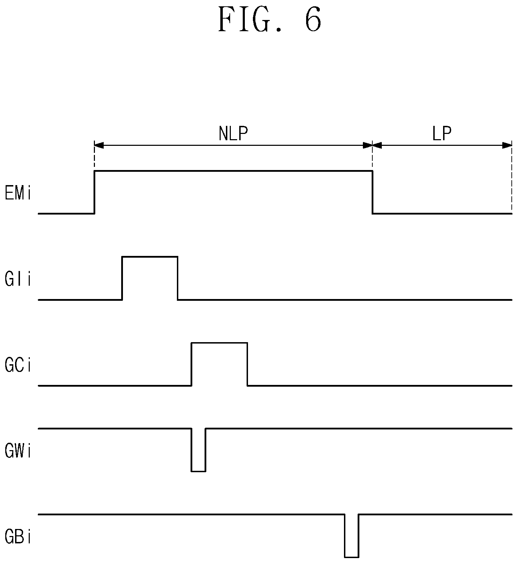

FIG. 6 is a timing diagram of scan signals and light emitting signals for describing an operation of the pixel illustrated in FIG. 5.

Referring to FIGS. 5 and 6, the i^{th} light emitting signal EMi may have a high level during a non-light emitting period NLP and have a low level during a light emitting period LP.

An activation period of each of the i^{th} writing scan signal GWi and the i^{th} bias scan signal GBi may be defined as a low level of each of the i^{th} writing scan signal GWi and the i^{th} bias scan signal GBi.

An activation period of each of the i^{th} compensation scan signal GCi and the i^{th} initialization scan signal GIi may be defined as a high level of each of the i^{th} compensation scan signal GCi and the i^{th} initialization scan signal GIi.

After the i^{th} initialization scan signal GIi is activated, the i^{th} compensation scan signal GCi and the i^{th} writing scan signal GWi may be activated. Thereafter, the i^{th} bias scan signal GBi may be activated.

During the non-light emitting period NLP, the i^{th} initialization scan signal GIi, the i^{th} compensation scan signal GCi, the i^{th} writing scan signal GWi, and the i^{th} bias scan signal GBi that are activated may be applied to the pixel PXij.

The i^{th} initialization scan signal GIi may be applied to the fourth transistor T4 to turn on the fourth transistor T4. The first initialization voltage VINT may be provided to the first node N1 through the fourth transistor T4. Thus, the first initialization voltage VINT may be applied to the control electrode of the first transistor T1, and the first transistor T1 may be initialized by the first initialization voltage VINT. This operation may be defined as an initialization operation.

The i^{th} writing scan signal GWi may be applied to the second transistor T2 to turn on the second transistor T2. Further, the i^{th} compensation scan signal GCi may be applied to the third transistor T3 to turn on the third transistor T3.

The first transistor T1 and the third transistor T3 may be diode-connected to each other. A compensated voltage VD-Vth obtained by subtracting the data voltage VD supplied through the jth data line DLj by a threshold voltage Vth of the first transistor T1 may be applied to the control electrode of the first transistor T1. This operation may be defined as a writing operation (or a programming operation) and a compensation operation.

The first driving voltage ELVDD and the compensation voltage VD-Vth may be applied to the first electrode and the second electrode of the capacitor CST. A charge corresponding to a difference between a voltage of the first electrode of the capacitor CST and a voltage of the second electrode of the capacitor CST may be stored in the capacitor CST.

Thereafter, the i^{th} bias scan signal GBi may be applied to the seventh and eighth transistors T7 and T8 to turn on the seventh and eighth transistors T7 and T8. The second initialization voltage VAINT may be provided to the anode AE through the seventh transistor T7, so that the anode AE may be initialized through the second initialization voltage VAINT. The bias voltage VBIAS may be applied to the first electrode of the first transistor T1 through the eighth transistor T8.

Thereafter, during the light emitting period LP, the i^{th} light emitting signal EMi may be applied to the fifth transistor T5 and the sixth transistor T6 through the i^{th} light emitting line EMLi to turn on the fifth transistor T5 and the sixth transistor T6. A driving current Id corresponding to a difference between a voltage of the control electrode of the first transistor T1 and the first driving voltage ELVDD may be generated. The driving current Id may be provided to the light emitting element OLED through the sixth transistor T6 so that the light emitting element OLED may emit light.

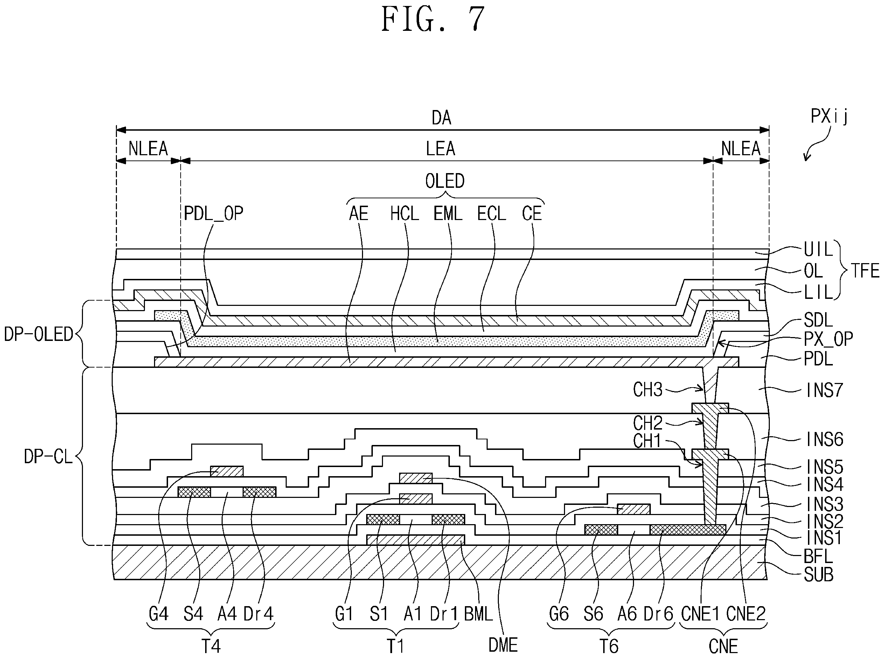

FIG. 7 is a schematic cross-sectional view of a light emitting element, a first transistor, a fourth transistor, and a sixth transistor of the pixel illustrated in FIG 5.

Referring to FIG. 7, the light emitting element OLED may include a first electrode AE, a second electrode CE, a hole control layer HCL, an electron control layer ECL, and a light emitting layer EML. The first electrode AE may be the anode AE illustrated in FIG. 5, and the second electrode CE may be the cathode CE illustrated in FIG. 5. The second electrode CE may be disposed above the first electrode AE, and the hole control layer HCL, the electron control layer ECL, and the light emitting layer EML may be disposed between the first electrode AE and the second electrode CE.

The first, fourth, and sixth transistors T1, T4, and T6 and the light emitting element OLED may be disposed on the substrate SUB. The display area DA may include a light emitting area LEA corresponding to the pixel PXij and a non-light emitting area NLEA adjacent to the light emitting area LEA. The light emitting element OLED may be disposed in the light emitting area LEA.

A lower metal layer BML may be disposed on the substrate SUB. The lower metal layer BML may overlap the first transistor T1. Although not illustrated, a constant voltage may be applied to the lower metal layer BML. In a case that the constant voltage is applied to the lower metal layer BML, the threshold voltage Vth of the first transistor T1 disposed on the lower metal layer BML may be maintained without changing.

The lower metal layer BML may block light input to the first transistor T1 from a lower side of the lower metal layer BML. The lower metal layer BML may include a reflective metal. The lower metal layer BML may be omitted.

A buffer layer BFL may be disposed on the substrate SUB, and the buffer layer BFL may be an inorganic layer. The buffer layer BFL may cover the lower metal layer BML. Semiconductor layers S1, A1, and Dr1 of the first transistor T1 and semiconductor layers S6, A6, and Dr6 of the sixth transistor T6 may be disposed on the buffer layer BFL. The semiconductor layers S1, A1, Drl, S6, A6, and Dr6 may include polysilicon. However, the disclosure is not limited thereto, and the semiconductor layers S1, A1, Dr1, S6, A6, and Dr6 may include amorphous silicon.

The semiconductor layers S1, A1, Drl, S6, A6, and Dr6 may be doped with N-type dopants or P-type dopants. The semiconductor layers S1, A1, Drl, S6, A6, and Dr6 may include a high doped area and a low doped area. The high doped area may have conductivity that may be greater than conductivity of the low doped area and substantially serve as source electrodes and drain electrodes of the first and sixth transistors T1 and T6. The low doped area may substantially correspond to active areas (or channels) of the first and sixth transistors T1 and T6.

The first source area S1, the first channel area A1, and the first drain area Dr1 of the first transistor T1 may be formed from the semiconductor layers S1, A1, and Dr1. The sixth source area S6, the sixth channel area A6, and the sixth drain area Dr6 of the sixth transistor T6 may be formed from the semiconductor layers S6, A6, and Dr6. The first channel area A1 may be disposed between the first source area S1 and the first drain area Dr1. The sixth channel area A6 may be disposed between the sixth source area S6 and the sixth drain area Dr6.

A first insulating layer INS1 may be disposed on the buffer layer BFL to cover the semiconductor layers S1, A1, Drl, S6, A6, and Dr6. A first gate electrode G1 (or a control electrode) of the first transistor T1 and a sixth gate electrode G6 (or a control electrode) of the sixth transistor T6 may be disposed on the first insulating layer INS1. In a plan view, the first gate electrode G1 may overlap the first channel area A1, and the sixth gate electrode G6 may overlap the sixth channel area A6.

Although not illustrated, structures of a source area, a channel area, a drain area, and a gate electrode of each of the second, fifth, and seventh transistors T2, T5, and T7 may be substantially the same as those of the first and sixth transistors T1 and T6.

A second insulating layer INS2 may be disposed on the first insulating layer INS1 to cover the first and sixth gate electrodes G1 and G6. A dummy electrode DME may be disposed on the second insulating layer INS2. The dummy electrode DME may be disposed on the first gate electrode G1 and may overlap the first gate electrode G1 in a plan view. The dummy electrode DME may form the capacitor CST together with the first gate electrode G1.

A third insulating layer INS3 may be disposed on the second insulating layer INS2 to cover the dummy electrode DME. Semiconductor layers S4, A4, and Dr4 of the fourth transistor T4 may be disposed on the third insulating layer INS3. The semiconductor layers S4, A4, and Dr4 may include an oxide semiconductor formed of a metal oxide. The oxide semiconductor may include a crystalline or amorphous oxide semiconductor.

The semiconductor layers S4, A4, and Dr4 may include multiple areas divided depending on whether or not the metal oxide is reduced. An area (hereinafter, referred to as a reduced area) in which the metal oxide is reduced has higher conductivity than that of an area (hereinafter, a non-reduced area) in which the metal oxide may not be reduced. The reduced area may substantially serve as a source electrode or a drain electrode of the fourth transistor T4. The non-reduced area may substantially correspond to an active area (or a channel) of the fourth transistor T4.

The fourth source area S4, the fourth channel area A4, and the fourth drain area Dr4 of the fourth transistor T4 may be formed from the semiconductor layers S4, A4, and Dr4. The fourth channel area A4 may be disposed between the fourth source area S4 and the fourth drain area Dr4.

A fourth insulating layer INS4 may be disposed on the third insulating layer INS3 to cover the semiconductor layers S4, A4, and Dr4. A fourth gate electrode G4 of the fourth transistor T4 may be disposed on the fourth insulating layer INS4. In a plan view, the fourth gate electrode G4 may overlap the fourth channel area A4.

A fifth insulating layer INS5 may be disposed on the fourth insulating layer INS4 to cover the fourth gate electrode G4. Although not illustrated, structures of a source area, a channel area, a drain area, and a gate electrode of the third transistor T3 may be substantially the same as those of the fourth transistor T4.

The buffer layer BFL and the first to fifth insulating layers INS1 to INS5 may include inorganic layers. Illustratively, the buffer layer BFL, the first insulating layer INS1, and the fourth insulating layer INS4 may include a silicon oxide layer, and the second insulating layer INS2 may include a silicon nitride layer.

The third and fifth insulating layers INS3 and INS5 may include multiple inorganic insulating layers including different materials and laminated on each other. For example, the third insulating layer INS3 may include a silicon nitride layer and a silicon oxide layer that are sequentially laminated, and the fifth insulating layer INS5 may include a silicon oxide layer and a silicon nitride layer that are sequentially laminated. A thickness of each of the third and fifth insulating layers INS3 and INS5 may be greater than a thickness of each of the buffer layer BFL and the first, second, and fourth insulating layers INS1, INS2, and INS4.

A connection electrode CNE may be disposed between the sixth transistor T6 and the light emitting element OLED. The connection electrode CNE may electrically connect the sixth transistor T6 and the light emitting element OLED. The connection electrode CNE may include a first connection electrode CNE1 and a second connection electrode CNE2 disposed on the first connection electrode CNE1.

The first connection electrode CNE1 may be disposed on the fifth insulating layer INS5 and may be connected to the sixth drain area Dr6 through a first contact hole CH1 defined by the first to fifth insulating layers INS1 to INS5. A sixth insulating layer INS6 may be disposed on the fifth insulating layer INS5 to cover the first connection electrode CNE1.

The second connection electrode CNE2 may be disposed on the sixth insulating layer INS6. The second connection electrode CNE2 may be connected to the first connection electrode CNE1 through a second contact hole CH2 defined by the sixth insulating layer INS6.

A seventh insulating layer INS7 may be disposed on the sixth insulating layer INS6 to cover the second connection electrode CNE2. The sixth and seventh insulating layers INS6 and INS7 may include inorganic layers or organic layers.

The first electrode AE may be disposed on the seventh insulating layer INS7. The first electrode AE may be electrically connected to the second connection electrode CNE2 through a third contact hole CH3 defined by the seventh insulating layer INS7.

A pixel defining film PDL, through which a portion (e.g., predetermined or selectable portion) of the first electrode AE is exposed, may be disposed on the first electrode AE and the seventh insulating layer INS7. A first opening PDL_OP, through which the portion (e.g., predetermined or selectable portion) of the first electrode AE is exposed, may be defined in the pixel defining film PDL.

A spacer SDL may be disposed on the pixel defining film PDL. The spacer SDL may include an organic material and may support a mask used in a process of depositing the light emitting layer EML. A second opening PX_OP that overlaps the first opening PDL_OP may be defined in the spacer SDL.

The hole control layer HCL may be disposed on the first electrode AE and the spacer SDL. The hole control layer HCL may be commonly disposed in the light emitting area LEA and the non-light emitting area NLEA. The hole control layer HCL may include a hole transport layer and a hole injection layer.

The light emitting layer EML may be disposed on the hole control layer HCL. The light emitting layer EML may be disposed in an area corresponding to the second opening PX_OP. The light emitting layer EML may include an organic material and/or an inorganic material. The light emitting layer EML may generate light having any one of red, green, and blue.

The electron control layer ECL may be disposed on the light emitting layer EML and the hole control layer HCL. The electron control layer ECL may be commonly disposed in the light emitting area LEA and the non-light emitting area NLEA. The electron control layer ECL may include an electron transport layer and an electron injection layer.

The second electrode CE may be disposed on the electron control layer ECL. The second electrode CE may be commonly disposed in the pixels PX. For example, the second electrode CE may be commonly disposed on the light emitting layers EML of the pixels PX.

Layers such as the buffer layer BFL and the first to seventh insulating layer INS1 to INS7 may be defined as the circuit element layer DP-CL. A layer, on which the light emitting element OLED is disposed, may be defined as the display element layer DP-OLED.

The thin film encapsulation layer TFE may be disposed on the light emitting element OLED. The thin film encapsulation layer TFE may include a first inorganic layer LIL, an organic layer OL, and a second inorganic layer UIL that are sequentially laminated. The inorganic layers LIL and UIL may include inorganic materials and protect the pixels PX from moisture/oxygen. The organic layer OL may include an organic material and protect the pixels PX from foreign material such as dust particles.

The first driving voltage ELVDD may be applied to the first electrode AE, and the second driving voltage ELVSS may be applied to the second electrode CE. Holes and electrons injected into the light emitting layer EML may combine with each other to form excitons, and as the excitons transition to a ground state, the light emitting element OLED may emit light. The light emitting element OLED may emit light to display an image.

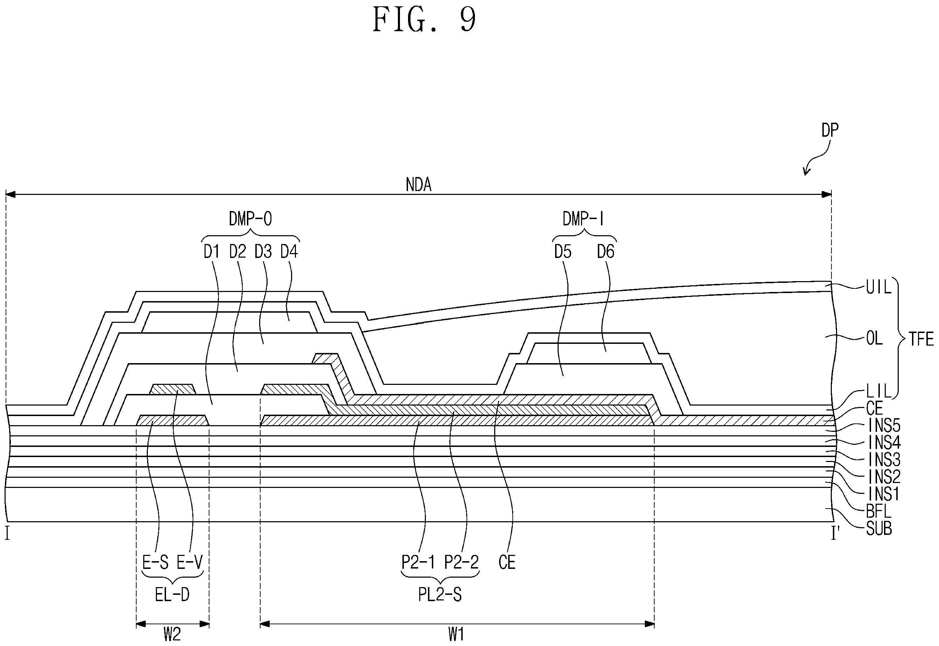

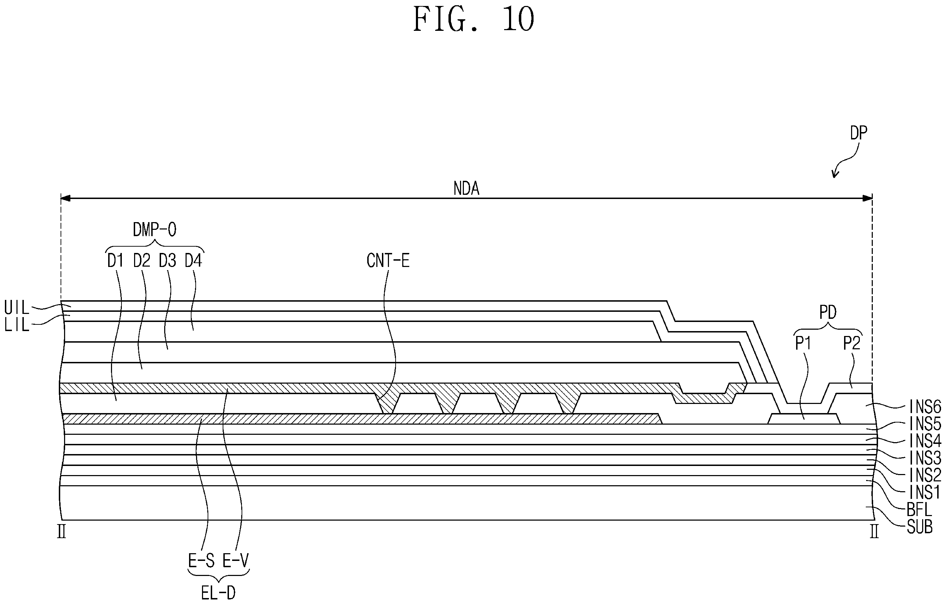

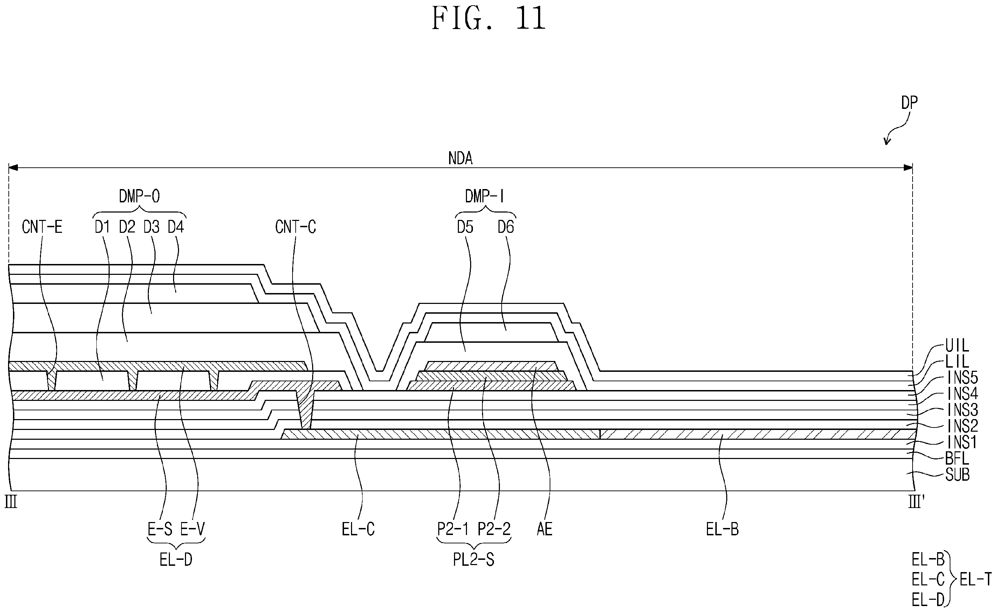

FIG. 8 is a schematic plan view of the display panel according to an embodiment of the disclosure. FIG. 9 is a schematic cross-sectional view along line I-I' of FIG. 8. FIG. 10 is a schematic cross-sectional view along line II-II' of FIG. 8. FIG. 11 is a schematic cross-sectional view along line III-III' of FIG. 8. The same/similar reference numerals are used for the same/similar components as FIGS. 1 to 7, and a duplicated description thereof will be omitted.

Referring to FIG. 8, the display panel DP may include the pixels PX, the data drivers DDV, multiple pads PD, the scan driver SDV (see FIG. 4), and the light emission driver EDV (see FIG. 4).

The display panel DP may include the display area DA and the non-display area NDA disposed around the display area DA and surrounding the display area DA. The display area DA may have a rounded corner quadrangular shape to correspond to the shape of the display panel DP.

The display panel DP may include the pixels PX, multiple scan lines SL1 to SLm, the data lines DL1 to DLn, the light emitting lines EML1 to EMLm, multiple first power lines PL1-1 to PL1-n, and the second power line PL2. The pixels PX may be disposed inside the display area DA. The pixels PX may be connected to the scan lines SL1 to SLm, the data lines DL1 to DLn, and the light emitting lines EML1 to EMLm.

The scan lines SL1 to SLm may include the scan lines GIL1 to GILm, GCL1 to GCLm, GWL1 to GWLm, and GBL1 to GBLm illustrated in FIG. 4. For example, among the scan lines SL1 to SLm, the i^{th} scan line may include the i^{th} writing scan line GWLi, the i^{th} compensation scan line GCLi, the i^{th} initialization scan line GILi, and the i^{th} bias scan line GBLi. Thus, the above-described scan signals may be applied to the pixels PX through the scan lines SL1 to SLm.

The data lines DL1 to DLn, the first power lines PL1-1 to PL1-n, the second power line PL2, and the light emitting lines EML1 to EMLm may be the same as the data lines DL1 to DLn, the first power line PL1, the second power line PL2, and the light emitting lines EML1 to EMLm illustrated in FIG. 4.

The scan driver SDV (see FIG. 4) and the light emission driver EDV (see FIG. 4) may be omitted in FIG. 8. However, the scan driver SDV (see FIG. 4) and the light emission driver EDV (see FIG. 4) may be disposed in the non-display area NDA adjacent to both sides of the display panel DP, which are opposite to each other in the first direction DR1, with the display area DA disposed between the scan driver SDV and the light emission driver EDV.

The data drivers DDV may be disposed at a lower end of the non-display area NDA and spaced (or disposed) apart from each other in the first direction DR1.

The first power lines PL1-1 to PL1-n may extend in the second direction DR2 inside the display area DA and may be connected to the pixels PX. Although not illustrated, ends of the first power lines PL1-1 to PL1-n may be connected to the pads PD, and opposite ends of the first power lines PL1-1 and PL1-n may be connected to a bridge line EL-B.

The second power line PL2 may include first lines PL2-1 to PL2-e and a second line PL2-S. The first lines PL2-1 to PL2-e may extend in the second direction DR2 and may be connected to the pixels PX. The second line PL2-S may be disposed in the non-display area NDA and may surround at least a portion of the display area DA. The first lines PL2-1 to PL2-e may extend from the display area DA to the non-display area NDA and may be connected to the second line PL2-S. Opposite ends of the second line PL2-S may be connected to the pads PD.

The scan lines SL1 to SLm may extend in the first direction DR1 and may be connected to the pixels PX and the scan driver SDV (see FIG. 4). The data lines DL1 to DLn may extend in the second direction DR2 and may be connected to the pixels PX and the data drivers DDV. The light emitting lines EML1 to EMLm may extend in the first direction DR1 and may be connected to the pixels PX and the light emission driver EDV (see FIG. 4).

The data drivers DDV may be spaced apart from each other in the first direction DR1. A number (e.g., predetermined or selectable number) of data lines may be connected to the data drivers DDV, respectively. Illustratively, two data drivers DDV are illustrated, but the number of data drivers DDV is not limited thereto. For example, as a length in the first direction DR1 of the display panel DP is increased, the number of data drivers DDV may be also increased.

The pads PD may be disposed in the non-display area NDA adjacent to a lower end of the display panel DP and may be closer to the lower end of the display panel DP than the data drivers DDV. The data drivers DDV may be connected to the pads PD. The data lines DL1 to DLn may be connected to the data drivers DDV, and the data drivers DDV may be connected to the pads PD corresponding to the data lines DL1 to DLn.

The timing controller T-C and the voltage generator VG illustrated in FIG. 4 may be mounted on a printed circuit board and may be connected to the pads PD through the printed circuit board.

The display panel DP according to an embodiment may include a detection line EL-T. The detection line EL-T may include extension lines EL-D, connection lines EL-C, and the bridge line EL-B.

The detection line EL-T may measure a dropped voltage value by sensing a difference between the first driving voltage ELVDD (see FIG. 5) transferred to the pixel PX disposed at a lower end of the display area DA adjacent to the pads PD and the first driving voltage ELVDD (see FIG. 5) transferred to the pixel PX disposed at an upper end of the display area DA among the pixels PX disposed in the same column in the second direction DR2. For example, an end of the first power line PL1 may be connected to the pad PD and an opposing end of the first power line PL1 may be connected to the bridge line EL-B. The bridge line EL-B may be connected to an end of the extension line EL-D through the connection line EL-C, and an opposing end of the extension line EL-D may be connected to the pad PD. Because materials, widths, and thicknesses of the extension line EL-D, the bridge line EL-B, and the connection line EL-C may be controlled, resistance values of the lines may be identified in advance.

A difference between an initial driving voltage value provided to the pixel PX disposed at a lowermost end of the display area DA and a decreased driving voltage value disposed at an uppermost end thereof may be sensed through the detection line EL-T, a voltage reduced by a resistance value of the detection line EL-T may be detected, and thus the voltage generator VG (see FIG. 4) may provide the compensated first driving voltage ELVDD (see FIG. 5). Accordingly, the display device DD according to an embodiment may provide the constant first driving voltage ELVDD (see FIG. 5) regardless of the size/area of the display area DA. Accordingly, the display device DD having improved reliability may be provided.

As the resistance values of the lines included in the detection line EL-T become smaller, the dropped voltage value may be more accurately measured and compensated for, so that low resistance of the lines included in the detection line EL-T may be required.

The detection line EL-T may include the extension lines EL-D, the connection lines EL-C, and the bridge line EL-B.

First portions of the extension lines EL-D may extend in the second direction DR2 and may be spaced apart from each other in the first direction DR1 by the display area DA. The second portions of the extension lines EL-D may extend in the first direction DR1, first ends of the second portions may be connected to the first portions, and the second and opposite ends of the second portions may be connected to the pad PD.

The bridge line EL-B may extend in the first direction DR1 and may be disposed above the display area DA. The first power lines PL1-1 to PL1-n may be connected to the bridge line EL-B.

The extension lines EL-D and the bridge line EL-B may be disposed on different layers or may be disposed on a same layer and may be spaced apart from each other.

The connection lines EL-C may be connected to the extension lines EL-D and the bridge line EL-B. The connection line EL-C disposed at an upper left side of the display area DA may be connected to a first end of a first extension line EL-D and a first end of the bridge line EL-B. A second end of the first extension line EL-D may be connected to the pad PD.

The connection line EL-C disposed at an upper right side of the display area DA may be connected to a first end of a second extension line EL-D and a second and opposite end of the bridge line EL-B. A second end of the second extension line EL-D may be connected to the pad PD.

According to an embodiment, the second line PL2-S may intersect the connection lines EL-C in a plan view. Thus, the second line PL2-S may be disposed on a different layer from the connection lines EL-C.

The connection lines EL-C may be spaced (or disposed) further apart from the display area DA than the second line PL2-S. Thus, the second line PL2-S may be disposed between the connection lines EL-C and the display area DA.

The bridge line EL-B may be closer to the display area DA than the second line PL2-S. Thus, the bridge line EL-B may be disposed between the second line PL2-S and the display area DA.

Referring to FIG. 9, the non-display area NDA of the display panel DP according to an embodiment may include a substrate SUB, the insulating layers BFL and INS1 to INS5 (or BFL, INS1, INS2, INS3, INS4, and INS5), and the thin film encapsulation layer TFE. The display panel DP according to an embodiment may include outer and inner dams DMP-O and DMP-I disposed along the non-display area NDA and surrounding at least a portion of the display area DA.

The outer dam DMP-O may surround at least a portion of the inner dam DMP-I, and the inner dam DMP-I may surround at least a portion of the display area DA. Thus, the outer dam DMP-O may be spaced further apart from the display area DA than the inner dam DMP-I.

The outer dam DMP-O may include a first dam pattern D1, a second dam pattern D2, a third dam pattern D3, and a fourth dam pattern D4 sequentially laminated on the fifth insulating layer INS5. The first dam pattern D1 may be formed and patterned in the same process as the sixth insulating layer INS6 described in FIG. 7 and the first dam pattern D1 and the sixth insulating layer INS6 may include a same material. The first dam pattern D1 may include an organic material.

The second dam pattern D2 may be disposed on the first dam pattern D1. The second dam pattern D2 may cover a side surface of the first dam pattern D1. The second dam pattern D2 may be formed and patterned in the same process as the seventh insulating layer INS7 described in FIG. 7 and the second dam pattern D2 and the seventh insulating layer INS7 may include a same material. The second dam pattern D2 may include an organic material.

The third dam pattern D3 may be disposed on the second dam pattern D2. The third dam pattern D3 may cover a side surface of the second dam pattern D2. The third dam pattern D3 may be formed and patterned in the same process as the pixel defining film PDL described in FIG. 7, and the third dam pattern D3 and the pixel defining film PDL may include a same material. The third dam pattern D3 may include an organic material.

The fourth dam pattern D4 may be disposed on the third dam pattern D3. The fourth dam pattern D4 may be formed and patterned in the same process as the spacer SDL described in FIG. 7, and the fourth dam pattern D4 and the spacer SDL may include a same material. The fourth dam pattern D4 may include an organic material.

The inner dam DMP-I may include fifth and sixth dam patterns D5 and D6 sequentially laminated on the fifth insulating layer INS5.

The fifth dam pattern D5 may be disposed on the fifth insulating layer INS5. The fifth dam pattern D5 may be formed and patterned in the same process as the pixel defining film PDL described in FIG. 7, and the fifth dam pattern D5 and the pixel defining film PDL may include a same material. Accordingly, the fifth dam pattern D5 may be formed in the same process as the third dam pattern D3.

The sixth dam pattern D6 may be disposed on the fifth dam pattern D5. The sixth dam pattern D6 may be formed and patterned in the same process as the spacer SDL described in FIG. 7, and the sixth dam pattern D6 and the spacer SDL may include a same material. Accordingly, the sixth dam pattern D6 may be formed in the same process as the fourth dam pattern D4.

At least one of the outer dam DMP-O and the inner dam DMP-I may define a boundary of the organic layer OL inside the non-display area NDA to prevent the organic layer OL from being overflowed to the outside of the substrate SUB in a process of forming the organic layer OL of the thin film encapsulation layer TFE. FIG. 9 illustrates that the organic layer OL is formed up to a side surface of the outer dam DMP-O, but the disclosure is not limited thereto, and the boundary of the organic layer OL may be defined by the inner dam DMP-I.

According to an embodiment, the extension line EL-D may include a sensing pattern E-S and a power pattern E-V. For example, the extension line EL-D included in the detection line EL-T may have a double wiring structure. The sensing pattern E-S and the power pattern E-V may be disposed inside the outer dam DMP-O. The description of the extension line EL-D illustrated in FIG. 9 may be equally applied to the extension line EL-D disposed on a right side in FIG. 8, and a duplicated description thereof will be omitted.

The sensing pattern E-S may be disposed on the fifth insulating layer INS5. In an embodiment, the sensing pattern E-S may be formed and patterned through the same process as the first connection electrode CNE1 described in FIG. 7. Thus, the sensing pattern E-S and the first connection electrode CNE1 may include a same material. The sensing pattern E-S may be covered by the first dam pattern D1.

The power pattern E-V may be disposed on the first dam pattern D1 and covered by the second dam pattern D2. In an embodiment, the power pattern E-V may be formed and patterned through the same process as the second connection electrode CNE2 described in FIG. 7. Thus, the power pattern E-V and the second connection electrode CNE2 may include a same material. The power pattern E-V may be covered by the second dam pattern D2. According to an embodiment, the extension line EL-D that measures a voltage value dropped from an initial driving voltage may have a double wiring structure, and thus the detection line EL-T having decreased resistance may be provided.

Referring to FIG. 10, the power pattern E-V may be connected to the sensing pattern E-S through contact holes CNT-E passing through the first dam pattern D1 in the non-display area NDA adjacent to the lower end of the display area DA. An end of the power pattern E-V may be connected to the pad PD.

Each of the pads PD described in FIG. 8 may include a first part P1 and a second part P2. The first part P1 may be disposed on the fifth insulating layer INS5. The second part P2 may be disposed on the sixth insulating layer INS6, disposed in a hole passing through the sixth insulating layer INS6, and connected to the first part P1. According to an embodiment, the power pattern E-V and the second part P2 may be an integrated pattern in which the power pattern E-V and the second part P2 are connected to each other.

Referring again to FIG. 9, the second line PL2-S of the second power line PL2 (see FIG. 7) according to an embodiment may include a first pattern P2-1 and a second pattern P2-2. The first pattern P2-1 and the second pattern P2-2 may extend from an inside of the inner dam DMP-I to an inside of the outer dam DMP-O. The first pattern P2-1 and the second pattern P2-2 may be in contact with each other inside the inner dam DMP-I and may be spaced apart from each other inside the outer dam DMP-O with the first dam pattern D1 disposed between the first pattern P2-1 and the second pattern P2-2. Inside the outer dam DMP-O, the first pattern P2-1 may be disposed between the fifth insulating layer INS5 and the first dam pattern D1, and the second pattern P2-2 may be disposed between the first dam pattern D1 and the second dam pattern D2.

The second line PL2-S may be in contact with the second electrode CE extending from the display area DA to the non-display area NDA. The second electrode CE may be disposed (e.g., directly disposed) on the second pattern P2-2. Inside the outer dam DMP-O, the second electrode CE may be spaced apart from the second pattern P2-2 with the second dam pattern D2 disposed between the second electrode CE and the second pattern P2-2. According to an embodiment and as illustrated in FIG. 9, a width (or line width) W1 of the second line PL2-S may be greater than a width W2 of the extension lines EL-D in a plan view.

Referring to FIG. 11, the power pattern E-V may be connected to the sensing pattern E-S through the contact holes CNT-E passing through the first dam pattern D1 in the non-display area NDA adjacent to the upper end of the display area DA (see FIG. 7). As described in FIGS. 10 and 11, the power pattern E-V and the sensing pattern E-S may be connected to each other through the contact holes CNT-E at the lower end and an upper end of the non-display area NDA with the display area DA disposed between the lower end and the upper end of the non-display area NDA. However, a position in which the power pattern E-V and the sensing pattern E-S are connected to each other through the contact holes CNT-E is not limited to an embodiment as long as the extension lines EL-D are disposed in the position.

According to an embodiment, the second line PL2-S of the second power line PL2 (see FIG. 7) may intersect the connection line EL-C in a plan view. For example, the second line PL2-S may be disposed on a different layer from the connection line EL-C, and the second line PL2-S and the connection line EL-C may overlap each other.

According to an embodiment, the connection line EL-C may be disposed on the first insulating layer INS1 and may be covered by the second insulating layer INS2. The connection line EL-C may be formed and patterned in the same process as the first gate electrode G1 described in FIG. 7 and the first connection line EL-C and the first gate electrode G1 may include a same material.

An end of the sensing pattern E-S may be connected to an end of the connection line EL-C through a contact hole CNT-C passing through the second to fifth insulating layers INS2 to INS5.

In an embodiment, the bridge line EL-B may be disposed on the first insulating layer INS1 and may be covered by the second insulating layer INS2. The bridge line EL-B may be formed and patterned in the same process as the first gate electrode G1 described in FIG. 7, and the bridge line EL-B and the first gate electrode G1 may include a same material. In an embodiment, the connection line EL-C and the bridge line EL-B may be formed through the same process and disposed on a same layer. Thus, the connection line EL-C and the bridge line EL-B may be integral with each other.

According to an embodiment, a double wiring structure may be formed to decrease the resistance value of the extension line EL-D, and thus the power pattern E-V, the sensing pattern E-S included in the extension line EL-D, and the first pattern P2-1 and the second pattern P2-2 included in the second line PL2-S may be disposed on a same layer. Thus, in order to prevent the extension line EL-D and the second line PL2-S from intersecting each other, the extension line EL-D and the bridge line EL-B may be connected to each other through the connection line EL-C. Thus, the connection line EL-C and the second line PL2-S may intersect (or overlap in a plan view without connecting) each other and be disposed on different layers.

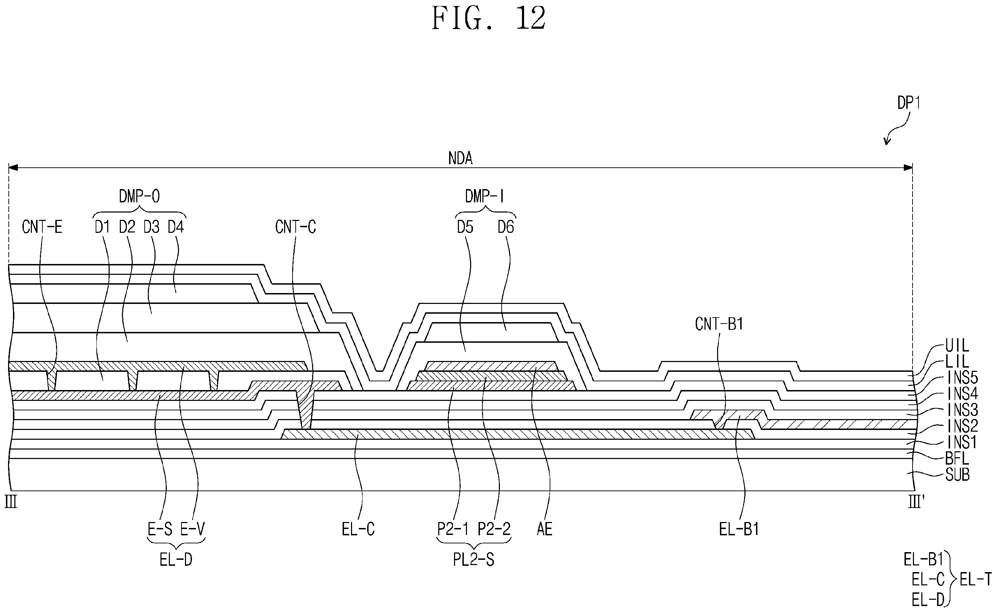

FIGS. 12 to 16 are schematic cross-sectional views of areas corresponding to FIG. 11. The same/similar reference numerals are used for the same/similar components as FIGS. 1 to 11, and a duplicated description thereof will be omitted.

Referring to FIG. 12, the non-display area NDA of a display panel DP1 according to an embodiment may include the substrate SUB, the insulating layers BFL and INS1 to INS5, the first and second inorganic layers LIL and UIL, the outer dam DMP-O, the inner dam DMP-I, the detection line EL-T, and the second line PL2-S of the second power line PL2 (see FIG. 7). The detection line EL-T may include the extension line EL-D, the connection line EL-C, and a bridge line EL-B1, and the extension line EL-D may include the sensing pattern E-S and the power pattern E-V. The second line PL2-S may include the first pattern P2-1 and the second pattern P2-2.

The power pattern E-V may be connected to the sensing pattern E-S through the contact holes CNT-E passing through the first dam pattern D1 in the non-display area NDA adjacent to the upper end of the display area DA (see FIG. 7).

The connection line EL-C may be disposed on the first insulating layer INS1 and may be covered by the second insulating layer INS2. The connection line EL-C may be formed and patterned in the same process as the first gate electrode G1 described in FIG. 7 and the connection line EL-C and the first gate electrode G1 may include a same material.

An end of the sensing pattern E-S may be connected to an end of the connection line EL-C through the contact hole CNT-C passing through the second to fifth insulating layers INS2 to INS5.

In an embodiment, the bridge line EL-B1 may be disposed on the second insulating layer INS2 and covered by the third insulating layer INS3. The bridge line EL-B1 may be formed and patterned in the same process of the dummy electrode DME described in FIG. 7 and the bridge line EL-B1 and the dummy electrode DME may include a same material. In an embodiment, the bridge line EL-B1 may be connected to another end of the connection line EL-C through a contact hole CNT-B1 passing through the second insulating layer INS2.

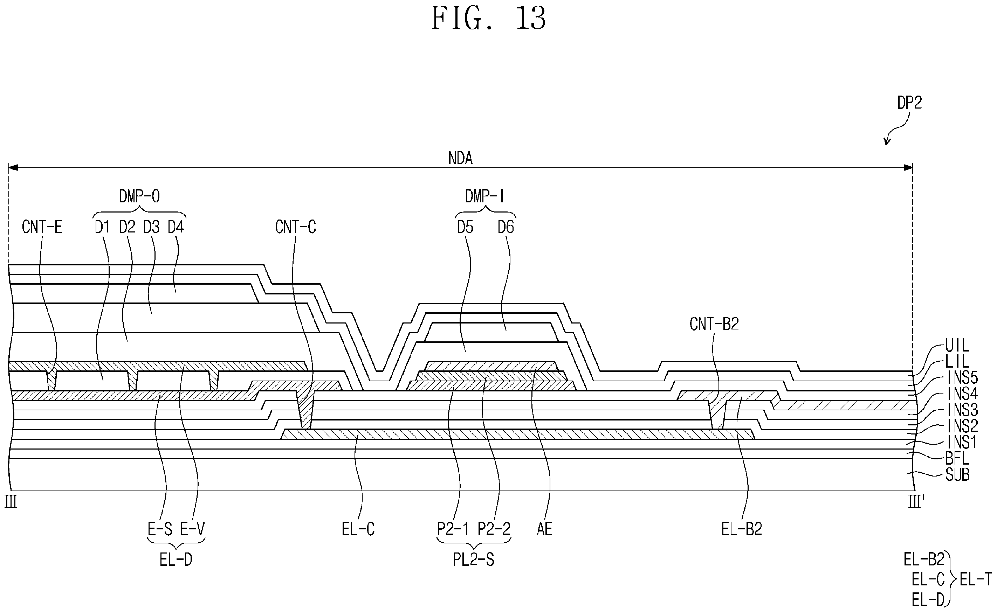

Referring to FIG. 13, the non-display area NDA of a display panel DP2 according to an embodiment may include the substrate SUB, the insulating layers BFL and INS1 to INS5, the first and second inorganic layers LIL and UIL, the outer dam DMP-O, the inner dam DMP-I, the detection line EL-T, and the second line PL2-S of the second power line PL2 (see FIG. 7). The detection line EL-T may include the extension line EL-D, the connection line EL-C, and a bridge line EL-B2, and the extension line EL-D may include the sensing pattern E-S and the power pattern E-V. The second line PL2-S may include the first pattern P2-1 and the second pattern P2-2.

The power pattern E-V may be connected to the sensing pattern E-S through the contact holes CNT-E passing through the first dam pattern D1 in the non-display area NDA adjacent to the upper end of the display area DA (see FIG. 7).

The connection line EL-C may be disposed on the first insulating layer INS1 and may be covered by the second insulating layer INS2. The connection line EL-C may be formed and patterned in the same process as the first gate electrode G1 described in FIG. 7 and the connection line EL-C and the first gate electrode G1 may include a same material.

An end of the sensing pattern E-S may be connected to an end of the connection line EL-C through the contact hole CNT-C passing through the second to fifth insulating layers INS2 to INS5.

In an embodiment, the bridge line EL-B2 may be disposed on the fourth insulating layer INS4 and covered by the fifth insulating layer INS5. The bridge line EL-B2 may be formed and patterned in the same process as the fourth gate electrode G4 (a second gate electrode in the appended claims) described in FIG. 7 and the bridge line EL-B2 and the fourth gate electrode G4 may include a same material. In an embodiment, the bridge line EL-B2 may be connected to another end of the connection line EL-C through the contact hole CNT-B2 passing through the second, third, fourth insulating layers INS2, INS3, and INS4.

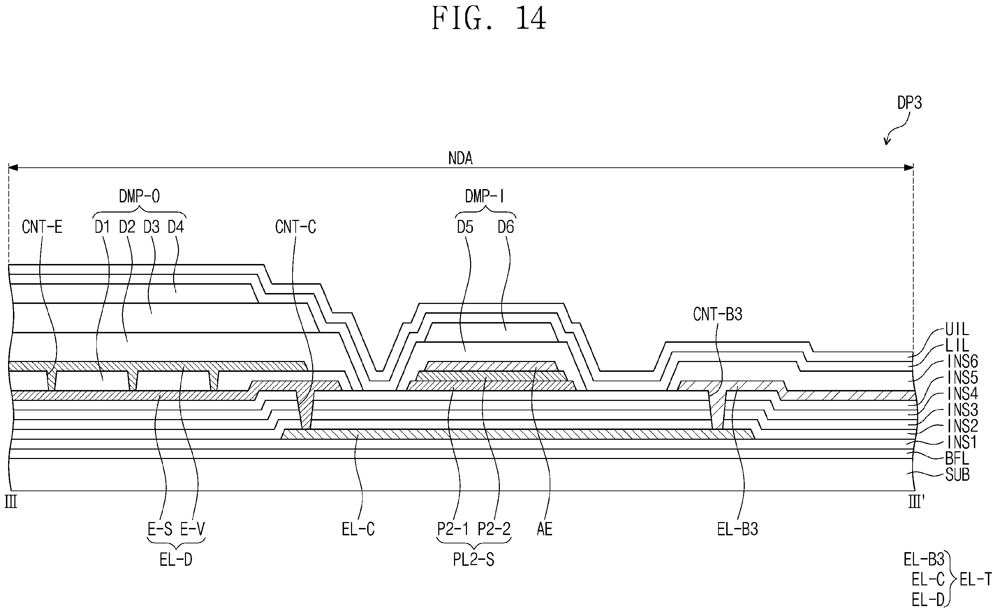

Referring to FIG. 14, the non-display area NDA of a display panel DP3 according to an embodiment may include the substrate SUB, the insulating layers BFL and INS1 to INS7, the first and second inorganic layers LIL and UIL, the outer dam DMP-O, the inner dam DMP-I, the detection line EL-T, and the second line PL2-S of the second power line PL2 (see FIG. 7). The detection line EL-T may include the extension line EL-D, the connection line EL-C, and a bridge line EL-B3, and the extension line EL-D may include the sensing pattern E-S and the power pattern E-V. The second line PL2-S may include the first pattern P2-1 and the second pattern P2-2.

The power pattern E-V may be connected to the sensing pattern E-S through the contact holes CNT-E passing through the first dam pattern D1 in the non-display area NDA adjacent to the upper end of the display area DA (see FIG. 7).

The connection line EL-C may be disposed on the first insulating layer INS1 and may be covered by the second insulating layer INS2. The connection line EL-C may be formed and patterned in the same process as the first gate electrode G1 described in FIG. 7 and the connection line EL-C and the first gate electrode G1 may include a same material.

An end of the sensing pattern E-S may be connected to an end of the connection line EL-C through the contact hole CNT-C passing through the second to fifth insulating layers INS2 to INS5.

In an embodiment, the bridge line EL-B3 may be disposed on the fifth insulating layer INS5 and covered by the sixth insulating layer INS6. The bridge line EL-B3 may be formed and patterned in the same process as the first connection electrode CNE1 described in FIG. 7 and the bridge line EL-B3 and the first connection line CNE1 may include a same material. In an embodiment, the bridge line EL-B3 may be connected to another end of the connection line EL-C through the contact hole CNT-B3 passing through the second to fifth insulating layers INS2 to INS5.

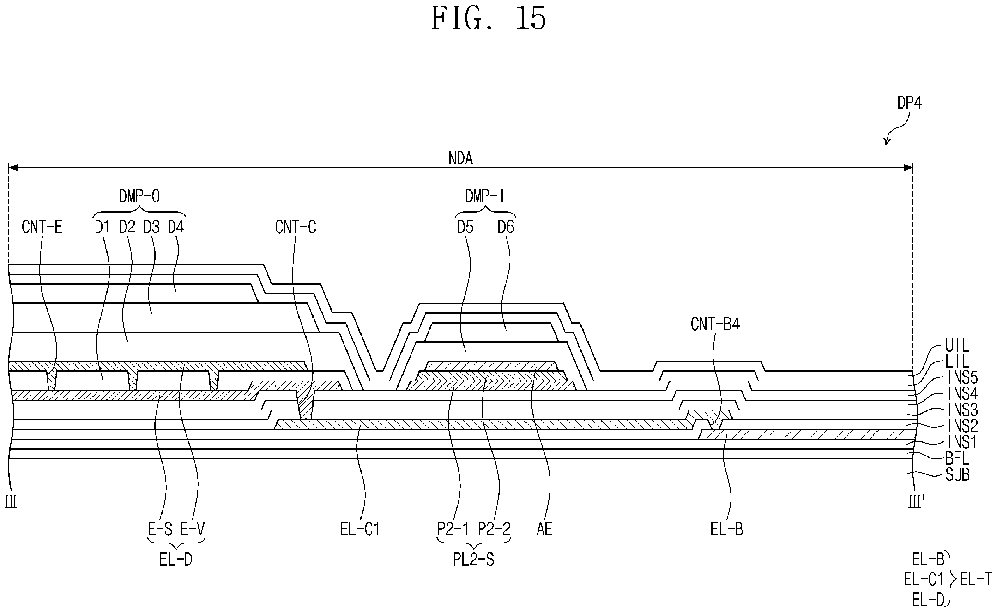

Referring to FIG. 15, the non-display area NDA of a display panel DP4 according to an embodiment may include the substrate SUB, the insulating layers BFL and INS1 to INS7, the first and second inorganic layers LIL and UIL, the outer dam DMP-O, the inner dam DMP-I, the detection line EL-T, and the second line PL2-S of the second power line PL2 (see FIG. 7). The detection line EL-T may include the extension line EL-D, a connection line EL-C1, and the bridge line EL-B, and the extension line EL-D may include the sensing pattern E-S and the power pattern E-V. The second line PL2-S may include the first pattern P2-1 and the second pattern P2-2.

The power pattern E-V may be connected to the sensing pattern E-S through the contact holes CNT-E passing through the first dam pattern D1 in the non-display area NDA adjacent to the upper end of the display area DA (see FIG. 7).

In an embodiment, the connection line EL-C1 may be disposed on the second insulating layer INS2 and covered by the third insulating layer INS3. The connection line EL-C1 may be formed and patterned in the same process of the dummy electrode DME described in FIG. 7 and the connection line EL-C1 and the dummy electrode DME may include a same material.

An end of the sensing pattern E-S may be connected to an end of the connection line EL-C1 through the contact hole CNT-C passing through the third to fifth insulating layers INS3 to INS5.

In an embodiment, the bridge line EL-B may be disposed on the first insulating layer INS1 and may be covered by the second insulating layer INS2. The bridge line EL-B may be formed and patterned in the same process as the first gate electrode G1 described in FIG. 7 and the bridge line EL-B and the first gate electrode G1 may include a same material. In an embodiment, another end of the connection line EL-C1 may be connected to the bridge line EL-B through the contact hole CNT-B4 passing through the second insulating layer INS2.

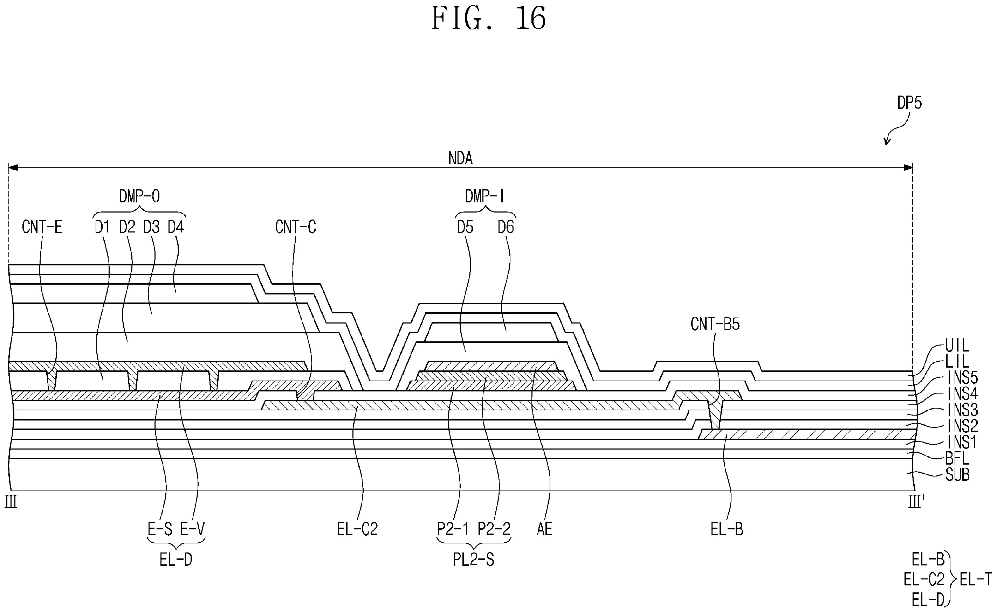

Referring to FIG. 16, the non-display area NDA of a display panel DP5 according to an embodiment may include the substrate SUB, the insulating layers BFL and INS1 to INS7, the first and second inorganic layers LIL and UIL, the outer dam DMP-O, the inner dam DMP-I, the detection line EL-T, and the second line PL2-S of the second power line PL2 (see FIG. 7). The detection line EL-T may include the extension line EL-D, a connection line EL-C2, and the bridge line EL-B, and the extension line EL-D may include the sensing pattern E-S and the power pattern E-V. The second line PL2-S may include the first pattern P2-1 and the second pattern P2-2.

The power pattern E-V may be connected to the sensing pattern E-S through the contact holes CNT-E passing through the first dam pattern D1 in the non-display area NDA adjacent to the upper end of the display area DA (see FIG. 7).

In an embodiment, the connection line EL-C2 may be disposed on the fourth insulating layer INS4 and covered by the fifth insulating layer INS5. The connection line EL-C2 may be formed and patterned in the same process as the fourth gate electrode G4 (the second gate electrode in the appended claims) described in FIG. 7 and the connection line EL-C2 and the fourth gate electrode G4 may include a same material.

An end of the sensing pattern E-S may be connected to an end of the connection line EL-C2 through the contact hole CNT-C passing through the fifth insulating layer INS5.

In an embodiment, the bridge line EL-B may be disposed on the first insulating layer INS1 and may be covered by the second insulating layer INS2. The bridge line EL-B may be formed and patterned in the same process as the first gate electrode G1 described in FIG. 7 and the bridge line EL-B and the first gate electrode G1 may include a same material. In an embodiment, another end of the connection line EL-C2 may be connected to the bridge line EL-B through the contact hole CNT-B5 passing through the second to fourth insulating layers layer INS2 to INS4.

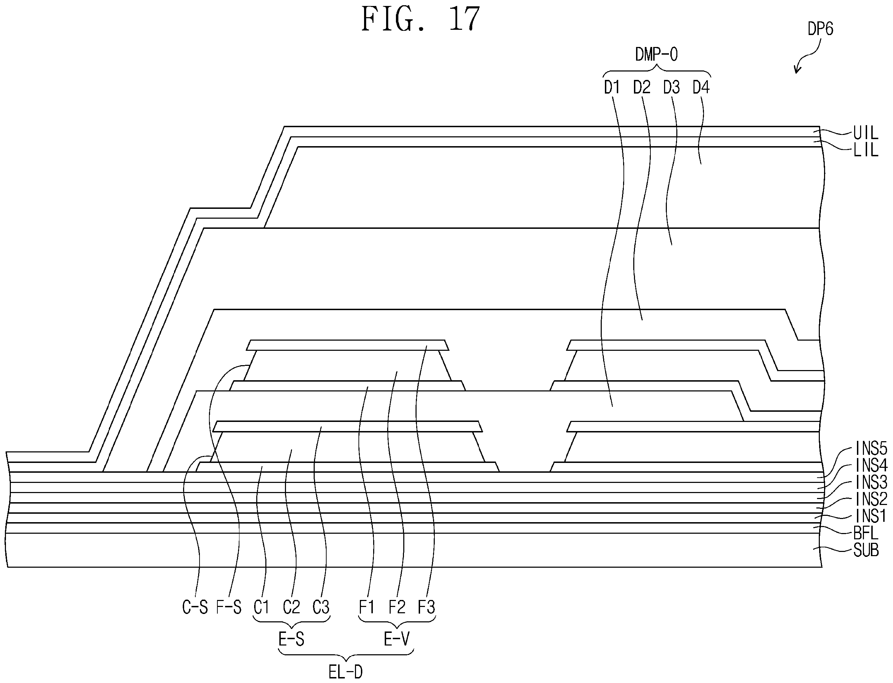

FIG. 17 is a schematic cross-sectional view of the display panel according to an embodiment. The same/similar reference numerals are used for the same/similar components as FIGS. 1 to 11, and a duplicated description thereof will be omitted.

According to an embodiment, the extension line EL-D may include the sensing pattern E-S and the power pattern E-V. The sensing pattern E-S and the power pattern E-V may be disposed inside the outer dam DMP-O. The outer dam DMP-O may include the first to fourth dam patterns D1, D2, D3, and D4 including organic materials.

The sensing pattern E-S may include first to third conductive patterns C1 to C3 that are sequentially laminated on the fifth insulating layer INS5, and the power pattern E-V may include first to third conductive patterns F1 to F3 that are sequentially laminated on the first dam pattern D1.

The first and third conductive patterns C1 and C3 may include titanium, and the second conductive pattern C2 may include aluminum. A thickness of the second conductive pattern C2 may be greater than thicknesses of the first and third conductive patterns C1 and C3. According to an embodiment, a side surface C-S of the second conductive pattern C2 may be recessed more inward from the sensing pattern E-S than side surfaces of the first and third conductive patterns C1 and C3. This may be formed by a difference between etch rates for etchants of the first to third conductive patterns C1 to C3.

The first and third conductive patterns F1 and F3 may include titanium, and the second conductive pattern F2 may include aluminum. The thickness of the second conductive pattern F2 may be greater than the thicknesses of the first and third conductive patterns F1 and F3. According to an embodiment, a side surface F-S of the second conductive pattern F2 may be recessed more inward from the power pattern E-V than side surfaces of the first and third conductive patterns F1 and F3. This may be formed by a difference between etch rates for etchants of the first to third conductive patterns F1 to F3.

According to an embodiment, the side surfaces C-S and F-S of the second conductive patterns C2 and F2 may be covered by an insulating layer including an organic material. For example, the side surface C-S of the second conductive pattern C2 may be covered by the first dam pattern D1, and the side surface F-S of the second conductive pattern F2 may be covered by the second dam pattern D2. Accordingly, oxidation of the side surfaces C-S and F-S of the second conductive patterns C2 and F2 may be prevented. Thus, a display panel DP6 including the extension line EL-D having improved reliability may be provided.

According to an embodiment of the disclosure, a constant driving voltage may be provided regardless of the size/area of a display area. Accordingly, a display device having improved reliability may be provided.

Although the description has been made above with reference to an embodiment of the disclosure, it may be understood that those skilled in the art or those having ordinary knowledge in the art may variously modify and change the disclosure without departing from the technical scope of the disclosure described in the appended claims.

Thus, the technical scope of the disclosure is not limited to the detailed description of the specification but should be defined by the appended claims.

Embodiments are set out in the following clauses:
Clause 1. A display device comprising:
   a substrate including a display area and a non-display area surrounding the display area;
   insulating layers disposed on the substrate;
   pixels disposed in the display area;
   first power lines disposed in a first direction, each of the first power lines extending in a second direction intersecting the first direction, the first power lines connected to the pixels and to provide a first driving voltage;
   a second power line including first lines disposed in the display area and connected to the pixels and a second line connected to the first lines, the second line disposed in the non-display area, the second power line to provide a second driving voltage, the second driving voltage having a lower voltage level than that of the first driving voltage; and
   a detection line disposed in the non-display area and surrounding at least a portion of the display area, wherein
   the detection line includes:
      extension lines each extending in the second direction and spaced apart from each other in the first direction by the display area;
      a bridge line extending in the first direction, connected to the first power lines, and including end portions; and
      connection lines connecting the end portions of the bridge line to corresponding ones of the extension lines, and
   the second line intersects the connection lines in a plan view.
Clause 2. The display device of clause 1, wherein
   the extension lines are disposed further apart from the display area than the second line, and
   the bridge line is disposed closer to the display area than the second line.
Clause 3. The display device of clause 1 or clause 2, wherein each of the extension lines includes a sensing pattern and a power pattern disposed on the sensing pattern and connected to the sensing pattern.
Clause 4. The display device of any of clauses 1-3, further comprising:
   an outer dam disposed in the non-display area and surrounding the at least a portion of the display area; and
   an inner dam disposed between the outer dam and the display area, wherein
   the outer dam includes a first dam pattern, a second dam pattern, a third dam pattern, and a fourth dam pattern sequentially laminated on the insulating layers, and
   the inner dam includes a fifth dam pattern and a sixth dam pattern sequentially laminated on the insulating layers.
Clause 5. The display device of clause 4, wherein
   the sensing pattern is covered by the first dam pattern,
   the power pattern is disposed on the first dam pattern and is covered by the second dam pattern, and
   the power pattern is connected to the sensing pattern through at least one contact hole passing through the first dam pattern.
Clause 6. The display device of clause 5, wherein
   each of the sensing pattern and the power pattern includes a first conductive pattern, a second conductive pattern, and a third conductive pattern that are sequentially laminated,
   the first conductive pattern and the third conductive pattern include titanium,
   the second conductive pattern includes aluminum, and
   a side surface of the second conductive pattern is recessed inward from a side surface of each of the first conductive pattern and the third conductive pattern.
Clause 7. The display device of clause 6, wherein
   the first dam pattern and the second dam pattern include organic materials,
   the first dam pattern covers the side surface of each of the first conductive pattern, the second conductive pattern and the third conductive pattern of the sensing pattern, and
   the second dam pattern covers the side surface of each of the first conductive pattern, the second conductive pattern and the third conductive pattern of the power pattern.
Clause 8. The display device of any of clauses 4-7, wherein
   the second line extends from an inside of the inner dam to an inside of the outer dam, the second line includes a first pattern and a second pattern disposed on the first pattern, the first pattern and the sensing pattern include a same material, and the second pattern and the power pattern include a same material.
Clause 9. The display device of clause 8, wherein the first pattern and the second pattern are in contact with each other inside the inner dam and are spaced apart from each other inside the outer dam with the first dam pattern disposed between the first pattern and the second pattern.
Clause 10. The display device of clause 9, wherein
   each of the pixels includes an anode, a cathode disposed on the anode, and a light emitting layer disposed between the anode and the cathode, and
   the cathode extends to the non-display area and is in contact with the second pattern.
Clause 11. The display device of clause 10, wherein
   each of the pixels further includes:
      a lower metal layer disposed on the substrate;
      a first semiconductor layer overlapping the lower metal layer;
      a first gate electrode overlapping the first semiconductor layer;
      a dummy electrode overlapping the first gate electrode;
      a second semiconductor layer spaced apart from the first semiconductor layer; and
      a second gate electrode overlapping the second semiconductor layer, and
   each of the pixels further includes a first connection electrode connected to the first semiconductor layer and a second connection electrode connecting the first connection electrode and the anode.
Clause 12. The display device of clause **11,** wherein
   the insulating layers include:
      a buffer layer disposed on the substrate to cover the lower metal layer;
      a first insulating layer disposed on the buffer layer to cover the first semiconductor layer;
      a second insulating layer disposed on the first insulating layer to cover the first gate electrode;
      a third insulating layer disposed on the second insulating layer to cover the dummy electrode;
      a fourth insulating layer disposed on the third insulating layer to cover the second semiconductor layer;
      a fifth insulating layer disposed on the fourth insulating layer to cover the second gate electrode;
      a sixth insulating layer disposed on the fifth insulating layer to cover the first connection electrode, the sixth insulating layer including an organic material; and
      a seventh insulating layer disposed on the sixth insulating layer to cover the second connection electrode, the seventh insulating layer including an organic material,
   the first connection electrode is connected to the first semiconductor layer through a first contact hole passing through the first insulating layer, the second insulating layer, the third insulating layer, the fourth insulating layer, and the fifth insulating layer,
   the second connection electrode is connected to the first connection electrode through a second contact hole passing through the sixth insulating layer, and
   the anode is connected to the second connection electrode through a third contact hole passing through the seventh insulating layer.
Clause 13. The display device of clause 12, further comprising:
   a pixel defining film including an organic material disposed on the seventh insulating layer, the pixel defining film including first openings defined through which at least portions of the anodes are exposed; and
   a spacer including an organic material disposed on the pixel defining film, the spacer including second openings defined overlapping the first openings.
Clause 14. The display device of clause 13, wherein
   the first dam pattern and the sixth insulating layer include a same material,
   the second dam pattern and the seventh insulating layer include a same material,
   the third dam pattern, the fifth dam pattern, and the pixel defining film include a same material, and
   the fourth dam pattern, the sixth dam pattern, and the spacer include a same material.
Clause 15. The display device of any of clauses 12-14, wherein
   the sensing pattern and the first connection electrode include a same material, and
   the power pattern and the second connection electrode include a same material.
Clause 16. The display device of clause 15, wherein
   the connection lines are disposed on the first insulating layer and are covered by the second insulating layer,
   the connection lines and the first gate electrode include a same material, and
   the sensing pattern is connected to the connection lines through contact holes passing through the second insulating layer, the third insulating layer, the fourth insulating layer and the fifth insulating layer.
Clause 17. The display device of clause 15 or clause 16, wherein
   the bridge line is disposed on the first insulating layer and is covered by the second insulating layer, and
   the connection lines and the bridge line are integral with each other.
Clause 18. The display device of clause 15, wherein
   the bridge line is disposed on the second insulating layer,
   the bridge line is covered by the third insulating layer,
   the bridge line and the dummy electrode include a same material, and
   the bridge line is connected to the connection lines through contact holes passing through the second insulating layer.
Clause 19. The display device of clause 15, wherein
   the bridge line is disposed on the fourth insulating layer,
   the bridge line is covered by the fifth insulating layer,
   the bridge line and the second gate electrode include a same material, and
   the bridge line is connected to the connection lines through contact holes passing through the second insulating layer, the third insulating layer, and the fourth insulating layer.
Clause 20. The display device of clause 15, wherein
   the bridge line is disposed on the first insulating layer,
   the bridge line is covered by the second insulating layer,
   the bridge line and the first gate electrode include a same material,
   the connection lines are disposed on the second insulating layer,
   the connection lines are covered by the third insulating layer,
   the connection lines and the dummy electrode include a same material,
   the sensing pattern is connected to an end portion of the connection lines through contact holes passing through the third insulating layer, the fourth insulating layer and the fifth insulating layer, and
   another end portion of the connection lines are connected to the bridge line through contact holes passing through the second insulating layer.
Clause 21. The display device of clause 15, wherein
   the bridge line is disposed on the first insulating layer,
   the bridge line is covered by the second insulating layer,
   the bridge line and the first gate electrode include a same material,
   the connection lines are disposed on the fourth insulating layer,
   the connection lines are covered by the fifth insulating layer,
   the connection lines and the second gate electrode include a same material,
   the sensing pattern is connected to an end portion of the connection lines through contact holes passing through the fifth insulating layer, and
   another end portion of the connection lines are connected to the bridge line through contact holes passing through the second insulating layer, the third insulating layer, and the fourth insulating layer.
Clause 22. The display device of any preceding clause, wherein a width of the second line is greater than a width of each of the extension lines in a plan view.

## Claims

1. A display device comprising:
a substrate including a display area and a non-display area surrounding the display area;
insulating layers disposed on the substrate;
pixels disposed in the display area;
first power lines disposed in a first direction, each of the first power lines extending in a second direction intersecting the first direction, the first power lines connected to the pixels and to provide a first driving voltage;
a second power line including first lines disposed in the display area and connected to the pixels and a second line connected to the first lines, the second line disposed in the non-display area, the second power line to provide a second driving voltage, the second driving voltage having a lower voltage level than that of the first driving voltage; and
a detection line disposed in the non-display area and surrounding at least a portion of the display area, wherein
the detection line includes:
extension lines each extending in the second direction and spaced apart from each other in the first direction by the display area;
a bridge line extending in the first direction, connected to the first power lines, and including end portions; and
connection lines connecting the end portions of the bridge line to corresponding ones of the extension lines, and
the second line intersects the connection lines in a plan view.

2. The display device of claim 1, wherein
the extension lines are disposed further apart from the display area than the second line, and
the bridge line is disposed closer to the display area than the second line.

3. The display device of claim 1 or claim 2, wherein each of the extension lines includes a sensing pattern and a power pattern disposed on the sensing pattern and connected to the sensing pattern.

4. The display device of any of claims 1-3, further comprising:
an outer dam disposed in the non-display area and surrounding the at least a portion of the display area; and
an inner dam disposed between the outer dam and the display area, wherein
the outer dam includes a first dam pattern, a second dam pattern, a third dam pattern, and a fourth dam pattern sequentially laminated on the insulating layers, and
the inner dam includes a fifth dam pattern and a sixth dam pattern sequentially laminated on the insulating layers.

5. The display device of claim 4, when dependent on claim 3, wherein
the sensing pattern is covered by the first dam pattern,
the power pattern is disposed on the first dam pattern and is covered by the second dam pattern, and
the power pattern is connected to the sensing pattern through at least one contact hole passing through the first dam pattern.

6. The display device of claim 5, wherein
each of the sensing pattern and the power pattern includes a first conductive pattern, a second conductive pattern, and a third conductive pattern that are sequentially laminated,
the first conductive pattern and the third conductive pattern include titanium,
the second conductive pattern includes aluminum, and
a side surface of the second conductive pattern is recessed inward from a side surface of each of the first conductive pattern and the third conductive pattern; optionally
wherein
the first dam pattern and the second dam pattern include organic materials,
the first dam pattern covers the side surface of each of the first conductive pattern, the second conductive pattern and the third conductive pattern of the sensing pattern, and
the second dam pattern covers the side surface of each of the first conductive pattern, the second conductive pattern and the third conductive pattern of the power pattern.

7. The display device of any of claims 4-6, wherein
the second line extends from an inside of the inner dam to an inside of the outer dam, the second line includes a first pattern and a second pattern,
the first pattern and the sensing pattern include a same material, and
the second pattern and the power pattern include a same material; optionally wherein the first pattern and the second pattern are in contact with each other inside the inner dam and are spaced apart from each other inside the outer dam with the first dam pattern disposed between the first pattern and the second pattern.

8. The display device of claim 9, wherein
each of the pixels includes an anode, a cathode disposed on the anode, and a light emitting layer disposed between the anode and the cathode, and
the cathode extends to the non-display area and is in contact with the second pattern; optionally wherein
each of the pixels includes:
a lower metal layer disposed on the substrate;
a first semiconductor layer overlapping the lower metal layer;
a first gate electrode overlapping the first semiconductor layer;
a dummy electrode overlapping the first gate electrode;
a second semiconductor layer spaced apart from the first semiconductor layer;
and
a second gate electrode overlapping the second semiconductor layer, and
each of the pixels further includes a first connection electrode connected to the first semiconductor layer and a second connection electrode connecting the first connection electrode and the anode.

9. The display device of claim 8, wherein
the insulating layers include:
a buffer layer disposed on the substrate to cover the lower metal layer;
a first insulating layer disposed on the buffer layer to cover the first semiconductor layer;
a second insulating layer disposed on the first insulating layer to cover the first gate electrode;
a third insulating layer disposed on the second insulating layer to cover the dummy electrode;
a fourth insulating layer disposed on the third insulating layer to cover the second semiconductor layer;
a fifth insulating layer disposed on the fourth insulating layer to cover the second gate electrode;
a sixth insulating layer disposed on the fifth insulating layer to cover the first connection electrode, the sixth insulating layer including an organic material; and
a seventh insulating layer disposed on the sixth insulating layer to cover the second connection electrode, the seventh insulating layer including an organic material,
the first connection electrode is connected to the first semiconductor layer through a first contact hole passing through the first insulating layer, the second insulating layer, the third insulating layer, the fourth insulating layer, and the fifth insulating layer,
the second connection electrode is connected to the first connection electrode through a second contact hole passing through the sixth insulating layer, and
the anode is connected to the second connection electrode through a third contact hole passing through the seventh insulating layer.

10. The display device of claim 9, further comprising:
a pixel defining film including an organic material disposed on the seventh insulating layer, the pixel defining film including first openings defined through which at least portions of the anodes are exposed; and
a spacer including an organic material disposed on the pixel defining film, the spacer including second openings defined overlapping the first openings; optionally
wherein
the first dam pattern and the sixth insulating layer include a same material,
the second dam pattern and the seventh insulating layer include a same material,
the third dam pattern, the fifth dam pattern, and the pixel defining film include a same material, and
the fourth dam pattern, the sixth dam pattern, and the spacer include a same material.

11. The display device of claim 9 or claim 10, wherein
the sensing pattern and the first connection electrode include a same material, and
the power pattern and the second connection electrode include a same material.

12. The display device of claim **11,** wherein
the connection lines are disposed on the first insulating layer and are covered by the second insulating layer,
the connection lines and the first gate electrode include a same material, and
the power pattern is connected to the connection lines through contact holes passing through the second insulating layer, the third insulating layer, the fourth insulating layer and the fifth insulating layer; and/or
wherein
the bridge line is disposed on the first insulating layer and is covered by the second insulating layer, and
the connection lines and the bridge line are integral with each other.

13. The display device of claim 11, wherein
the bridge line is disposed on the second insulating layer,
the bridge line is covered by the third insulating layer, and
the bridge line and the dummy electrode include a same material, and
the bridge line is connected to the connection lines through contact holes passing through the second insulating layer; or
wherein
the bridge line is disposed on the fourth insulating layer,
the bridge line is covered by the fifth insulating layer,
the bridge line and the second gate electrode include a same material, and
the bridge line is connected to the connection lines through contact holes passing through the second insulating layer, the third insulating layer, and the fourth insulating layer.

14. The display device of claim 11, wherein
the bridge line is disposed on the first insulating layer,
the bridge line is covered by the second insulating layer,
the bridge line and the first gate electrode include a same material,
the connection lines are disposed on the second insulating layer,
the connection lines are covered by the third insulating layer,
the connection lines and the dummy electrode include a same material,
the sensing pattern is connected to an end portion of the connection lines through first contact holes passing through the third insulating layer, the fourth insulating layer and the fifth insulating layer, and
another end portion of the connection lines are connected to the bridge line through second contact holes passing through the second insulating layer; or
wherein
the bridge line is disposed on the first insulating layer,
the bridge line is covered by the second insulating layer,
the bridge line and the first gate electrode include a same material,
the connection lines are disposed on the fourth insulating layer,
the connection lines are covered by the fifth insulating layer,
the connection lines and the second gate electrode include a same material,
the sensing pattern is connected to an end portion of the connection lines through first contact holes passing through the fifth insulating layer, and
another end portion of the connection lines are connected to the bridge line through second contact holes passing through the second insulating layer, the third insulating layer, and the fourth insulating layer.

15. The display device of any preceding claim, wherein a width of the second line is greater than a width of each of the extension lines in a plan view.
